# EUROPEAN PATENT APPLICATION

(11) **EP 4 826 725 A1**
(43) Date of publication of application: **21.10.2026**
(21) Application number: 26166525.1
(22) Date of filing: 20.03.2026
(51) Int. Cl.: G11C 16/26

(54) **STORAGE DEVICE AND NONVOLATILE MEMORY DEVICE INCLUDING PLURALITY OF NAND STRINGS**

(30) Priority: 16.04.2025 KR 20250049416
(71) Applicant: Samsung Electronics Co., Ltd., Suwon-si, Gyeonggi-do 16677 (KR)
(72) Inventor: KIM, Youngjae, Suwon-si (KR); KANG, Kyung-Min, Suwon-si (KR); PARK, Jinwoo, Suwon-si (KR); WI, Jonguk, Suwon-si (KR); KANG, Dongku, Suwon-si (KR)
(74) Representative: Marks & Clerk LLP

(57) **Abstract**

A storage device includes a storage controller configured to output a command instructing reading of data, and a nonvolatile memory device including a plurality of NAND strings corresponding to a plurality of bit lines and a plurality of string selection lines, and configured to select a plurality of first bit lines among the plurality of bit lines based on the command, electrically connect a plurality of first NAND strings corresponding to the plurality of first bit lines among the plurality of NAND strings to the plurality of first bit lines and a common source line, and electrically disconnect a plurality of second NAND strings corresponding to a plurality of second bit lines among the plurality of NAND strings from the plurality of second bit lines and the common source line.

## Description

### BACKGROUND

Storage devices such as SSD (Solid State Drive) are mainly used in connection with a host device, and perform read operations, program operations, etc. in response to read requests and program requests from the host device.

SSD read operations are performed on a page-by-page basis. In response to a read request from the host device, the SSD reads data in page units. However, the size of read data requested by the host device may vary, and the SSD may dynamically set the page size according to the request of the host device.

Within an SSD, a page is formed by memory cells that share the same word line. However, when physically cutting word lines to dynamically set the page size, there is a problem that the area of the SSD increases.

### SUMMARY

Some embodiments relate to a storage device that outputs read data of various sizes.

According to some embodiments, a storage device comprises: a storage controller configured to output a command instructing reading of data, and a nonvolatile memory device including a plurality of NAND strings corresponding to a plurality of bit lines and a plurality of string selection lines, and configured to select a plurality of first bit lines among the plurality of bit lines based on the command, electrically connect a plurality of first NAND strings corresponding to the plurality of first bit lines among the plurality of NAND strings to the plurality of first bit lines and a common source line, and electrically disconnect a plurality of second NAND strings corresponding to a plurality of second bit lines among the plurality of NAND strings from the plurality of second bit lines and the common source line.

According to some embodiments, a nonvolatile memory device comprises: a memory cell array including a plurality of string selection transistors connected to a plurality of string selection lines and a plurality of bit lines including a plurality of bit line groups, a plurality of memory cells connected to a plurality of word lines, a plurality of bit line selection transistors connected to a plurality of bit line selection lines, and a plurality of ground selection transistors connected to a plurality of ground selection lines and a common source line, and a control circuit configured to apply a plurality of first voltages to the plurality of ground selection lines, connect a selected plurality of first string selection lines among the plurality of string selection lines to the common source line, select a first bit line group among the plurality of bit line groups, apply a plurality of second voltages to the plurality of bit line selection lines, and electrically connect a plurality of second NAND strings corresponding to the first bit line group, among a plurality of first NAND strings corresponding to the plurality of first string selection lines, to a corresponding plurality of bit lines and the common source line.

According to some embodiments, a storage device comprises: a memory controller configured to output a first command instructing reading of a first size data and a second command instructing reading of a second size data, and a nonvolatile memory device including a plurality of NAND strings, wherein the plurality of NAND strings include a plurality of string selection transistors connected to a plurality of bit lines including a plurality of bit line groups and a plurality of first string selection lines among a plurality of string selection lines, a plurality of memory cells connected to a plurality of word lines, a plurality of bit line selection transistors connected to a plurality of bit line selection lines, and a plurality of ground selection transistors connected to a plurality of ground selection lines and a common source line, and wherein the nonvolatile memory device is configured to program the plurality of bit line selection transistors with a plurality of first threshold voltages and apply a plurality of first voltages to the plurality of bit line selection lines based on the first command, and program the plurality of bit line selection transistors with a plurality of second threshold voltages and apply a plurality of second voltages to the plurality of bit line selection lines based on the second command.

According to some embodiments, a storage device includes a storage controller configured to output a command instructing reading of data, and a nonvolatile memory device. The nonvolatile memory device includes a plurality of bit lines extending in a first horizontal direction, a plurality of word lines extending in a second horizontal direction, a plurality of selection lines extending in the second horizontal direction, each selection line connecting to a set of selection transistors arranged in the second horizontal direction, a common source line, wherein the plurality of word lines and plurality of selection lines are vertically between the common source line and the plurality of bit lines, a plurality of string select lines extending in the second horizontal direction, and a plurality of NAND strings, each extending from a bit line of the plurality of bit lines to the common source line, and connected to the plurality of word lines, the plurality of selection lines, and one of the string select lines. The nonvolatile memory device is configured to, in response to the command, apply a first voltage to a group of selection transistors connected to a first selection line of the plurality of selection lines, and in response to applying of the first voltage, turn on a first set of selection transistors of the group of selection transistors, the first set of selection transistors having threshold voltages within a first threshold voltage distribution below the first voltage, and turn off a second set of selection transistors of the group of selection transistors, the second set of selection transistors having threshold voltages within a second threshold voltage distribution above the first voltage. Turning off of the second set of selection transistors electrically disconnects, for each turned-off selection transistor, the common source line from a bit line connected to the turned-off selection transistor.

At least some of the above and other features of the invention are set out in the claims.

### BRIEF DESCRIPTION OF THE DRAWINGS

FIG. 1 is a block diagram illustrating a nonvolatile memory device according to some embodiments.
FIG. 2 is a circuit diagram for explaining one memory cell block of the memory cell array of FIG. 1.
FIG. 3 is a diagram of a memory cell block of FIG. 2.
FIG. 4 is a diagram showing the threshold voltage distribution of ground selection transistors according to some embodiments.
FIG. 5 is a perspective view of a memory cell block according to some embodiments.
FIG. 6 is a plan view of a memory cell block according to some embodiments.
FIG. 7 is a diagram showing the structure of a memory cell block according to some embodiments.
FIG. 8 is a table showing the voltage applied to the bit line selection line and the states of the bit line selection transistors according to the voltage applied to the bit line selection line.
FIG. 9 is a perspective view of a memory cell block according to some embodiments.
FIG. 10 is a plan view of a memory cell block according to some embodiments.
FIG. 11 is a diagram showing the structure of a memory cell block according to some embodiments.
FIG 12 is a table showing the voltage applied to the bit line selection line and the states of the bit line selection transistors according to the voltage.
FIG 13 is a table showing the voltage applied to the bit line selection line and the states of the bit line selection transistors according to the voltage.
FIG. 14 is a perspective view of a memory cell block according to some embodiments.
FIG. 15 is a plan view of a memory cell block according to some embodiments.
FIG. 16 is a block diagram of a storage device according to some embodiments.

### DETAILED DESCRIPTION OF THE EMBODIMENTS

Below, with reference to the attached drawings, embodiments of the present invention are described in detail so that a person having ordinary skill in the art to which the present invention pertains may easily practice it. However, the present invention may be implemented in various different forms and is not limited to the embodiments described herein.

In order to clearly explain the present invention in the drawings, parts unrelated to the explanation may be omitted, and similar parts are given similar drawing reference numerals throughout the specification. In the flowchart described with reference to the drawings, the order of operations may be changed, several operations may be merged, some operations may be split, and certain operations may not be performed.

Additionally, expressions written in the singular may be interpreted as singular or plural, unless explicit expressions such as "only one" or "singular" are used. Terms that include ordinal numbers, such as first, second, etc., may be used to describe various components, but the components are not limited by these terms. These terms may be used to distinguish one component from another. In addition, in certain cases, even if a term is not described using "first," "second," etc., in the specification, it may still be referred to as "first" or "second" in a claim in order to distinguish different claimed elements from each other.

Components described as "connected" may be directly connected with no intervening elements therebetween, or may be indirectly connected with elements therebetween that connect the components. In general, components described as "electrically connected" are configured such that an electrical signal can be transferred from one component to the other (although such electrical signal may be attenuated in strength as it is transferred and may be selectively transferred). In addition, two components connected through one or more transistors, and that are configured to pass signals or voltage therebetween when the one or more transistors are in an on state and to not pass signals or voltage therebetween when at least one of the transistors is in an off state may be described as electrically connected when the one or more transistors are in the on state, and as electrically disconnected when at least one of the transistors is in an off state to prevent signals or voltage from passing between the two components. The term "actively electrically connected," may also be used to refer to components that are electrically connected through at least one active element that is in an "on" state to allow electrical signals to pass therethrough and "actively electrically disconnected," may also be used to refer to components that are electrically disconnected through at least one active element that is in an "off" state to prevent electrical signals from passing therethrough.

A "controller" as described herein may include one or more semiconductor chips (e.g., logic chips) that include hardware such as integrated circuits, and may be programmed using software. Such a controller is configured to carry out the various processes described herein, such as generating and transmitting commands, and transmitting and receiving data, addresses, and other information. A controller may be referred to as a storage controller or as a memory controller.

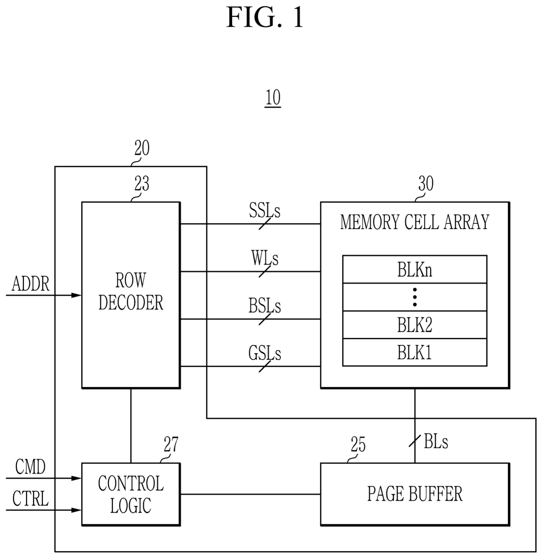

FIG. 1 is a block diagram illustrating a nonvolatile memory device according to some embodiments.

In some embodiments, a nonvolatile memory device 10 may include a memory cell array 30 and peripheral circuit 20. The nonvolatile memory device 10 may be implemented in the form of or as part of an SSD, a smart SSD, an embedded Multimedia Card eMMC, an embedded Universal Flash Storage UFS memory device, a UFS memory card, a Compact Flash CF, a Secure Digital SD card, a Micro-SD, a Mini-SD, an extreme Digital xD, a Memory Stick, or a similar form.

Referring to FIG. 1, the memory cell array 30 may include a plurality of memory cell blocks BLK1 to BLKn.

Each of memory cell blocks BLK1 to BLKn may include a plurality of memory cells. In some embodiments, the memory cell array 30 may be connected to peripheral circuit 20 via bit lines BLs, word lines WLs, string selection lines SSLs, ground selection lines GSLs, and bit line selection lines BSLs. The string selection lines SSLs, ground selection lines GSLs, and bit line selection lines BSLs are all selection lines that may be also described as "select lines" (e.g., string select lines, ground select lines, and bit line select lines). Specifically, memory cell blocks BLK1 to BLKn may be connected to a row decoder 23 through word lines WLs, string selection lines SSLs, ground selection lines GSLs, and bit line selection lines BSLs. Additionally, memory cell blocks BLK1 to BLKn may be connected to a page buffer 25 via bit lines BLs.

In some embodiments, the memory cell blocks BLK1 to BLKn may include a plurality of transistors, and the word lines WLs, string selection lines SSLs, ground selection lines GSLs, and bit line selection lines BSLs may each be connected to a plurality of transistors. For example, word lines WLs may be connected to the plurality of memory cells, string selection lines SSLs may be connected to the plurality of string selection transistors, ground selection lines GSLs may be connected to the plurality of ground selection transistors, and bit line selection lines BSLs may be connected to the plurality of bit line selection transistors. A plurality of memory cells, a plurality of string selection transistors, a plurality of ground selection transistors, and a plurality of bit line selection transistors may form a plurality of NAND strings.

In some embodiments, the ground selection transistors connected to the ground selection lines GSLs may be programmed to have a predetermined threshold voltage distribution. For example, ground selection transistors connected to ground selection lines GSLs may have a first threshold voltage distribution or a second threshold voltage distribution.

In some embodiments, bit line selection transistors connected to bit line selection lines BSLs may be programmed to have a predetermined threshold voltage distribution. For example, bit line selection transistors connected to bit line selection lines BSLs may have a first threshold voltage distribution or a second threshold voltage distribution.

The peripheral circuit 20 may receive an address ADDR, a command CMD, and a control signal CTRL from outside the nonvolatile memory device 10, and may transmit and receive data DATA with a device outside the nonvolatile memory device 10. The peripheral circuit 20 may include control logic (or control circuit) 27, a row decoder 23, and a page buffer 25. Although not shown, the peripheral circuit 20 may further include various sub-circuits, such as an input/output circuit, a voltage generation circuit that generates various voltages necessary for the operation of the nonvolatile memory device 10, and/or an error correction circuit for correcting errors in data DATA read from the memory cell array 30.

In some embodiments, the peripheral circuit 20 may receive a command CMD and an address ADDR that instruct a program operation and an erase operation from the outside. Additionally, the peripheral circuit 20 may receive a command CMD and an address ADDR that instruct a read operation from the outside. Specifically, the peripheral circuit 20 may receive a command CMD that instructs a read operation and an address ADDR where read data is stored. In some embodiments, a command CMD that instructs a read operation may include information about the size of data to be read.

Based on a command CMD and an address ADDR that instruct a read operation received from the outside, the peripheral circuit 20 may perform a read operation for the corresponding data. For example, the peripheral circuit 20 may select at least one of the memory cell blocks BLK1 to BLKn based on the address ADDR where the corresponding data is stored, and may select at least one word line WL, at least one string selection line SSL, at least one ground selection line GSL, and at least one bit line selection line BSL of the selected memory cell blocks BLK1 to BLKn. In addition, the peripheral circuit 20 may control voltage levels applied to ground selection lines GSLs and bit line selection lines BSLs connected to selected memory cell blocks BLK1 to BLKn based on a command CMD including an address ADDR where the corresponding data is stored and information on the size of data to be read. Accordingly, the nonvolatile memory device 10 may output read data of various sizes to the outside. Below, the operation of each component of the peripheral circuit 20 is described in detail.

The control logic 27 may be connected to various circuits within the row decoder 23 and peripheral circuit 20. Control logic 27 may control the overall operation of the nonvolatile memory device 10. The control logic 27 may generate various internal control signals used within the nonvolatile memory device 10 in response to a control signal CTRL. For example, the control logic 27 may adjust the voltage level provided to the word line WL and the bit line BL when performing a memory operation such as a program operation or an erase operation.

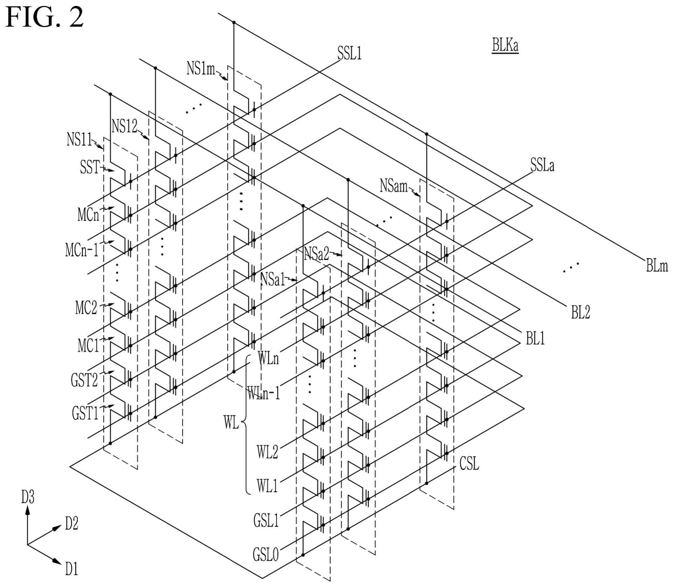

In some embodiments, the control logic 27 may control voltage levels applied to ground selection lines GSLs when performing a read operation. For example, the control logic 27 may control voltage levels applied to ground selection lines GSLs based on a command CMD when performing a read operation. The control logic 27 may control the ground selection transistors connected to the ground selection lines GSLs by controlling the voltage levels applied to the ground selection lines GSLs. For example, when voltages of a plurality of first voltage levels are applied to the ground selection lines GSLs under the control of the control logic 27, ground selection transistors connected to the ground selection lines GSLs having threshold voltages lower than the plurality of first voltage levels may be turned on, and ground selection transistors having threshold voltages higher than the plurality of first voltage levels may be turned off. The control logic 27 may control the connection between channels and common source lines within the memory cell array 30 by controlling voltage levels applied to ground selection lines GSLs. In this way, a structure that controls the connection between a channel and a common source line by using ground selection lines GSLs connected to transistors with different threshold voltages may be referred to as a coded GSL structure. A detailed description of the coded GSL structure is described below with reference to FIG. 2 to FIG. 6.

In some embodiments, the control logic 27 may control voltage levels applied to bit line selection lines BSLs when performing a read operation. For example, the control logic 27 may control voltage levels applied to bit line selection lines BSLs based on a command CMD when performing a read operation. The control logic 27 may control bit line selection transistors connected to bit line selection lines BSLs by controlling voltage levels applied to bit line selection lines BSLs. For example, when voltages of a plurality of second voltage levels are applied to the bit line selection lines BSLs under the control of the control logic 27, the bit line selection transistors BSTs connected to the bit line selection lines BSLs having threshold voltages lower than the plurality of second voltage levels may be turned on, and bit line selection transistors having threshold voltages higher than the plurality of second voltage levels may be turned off. The control logic 27 may control the connection of channels and bit lines and common source lines within the memory cell array 30 by controlling voltage levels applied to bit line selection lines BSLs. For example, the control logic 27 may electrically connect a channel within the memory cell array 30 and a selected bit line and a common source line by controlling voltage levels applied to bit line selection lines BSLs. Alternatively, the control logic 27 may electrically disconnect channels and unselected bit lines and common source lines within the memory cell array 30 by controlling voltage levels applied to the bit line selection lines BSLs.

In some embodiments, a read operation of a nonvolatile memory device 10 may be performed in units of physical pages formed within a memory cell array 30. The memory cells sharing the same word line may form a physical page. In some embodiments, the control logic 27 may dynamically set the size of a physical page by controlling voltage levels applied to ground selection lines GSLs and/or bit line selection lines BSLs. The nonvolatile memory device 10 according to some embodiments may output read data of various sizes according to a request from an external device.

In some embodiments, the row decoder 23 may select at least one of a plurality of memory cell blocks BLK1 to BLKn in response to an address ADDR, and may select at least one word line WL, at least one string selection line SSL, at least one ground selection line GSL, and at least one bit line selection line BSL of the selected memory cell blocks BLK1 to BLKn. Additionally, the row decoder 23 may transmit a voltage for performing a memory operation to the word line WL of the selected memory cell blocks BLK1 to BLKn. In some embodiments, the row decoder 23 may provide different voltage levels to each of the plurality of ground selection lines GSLs and the plurality of bit line selection lines BSLs under the control of the control logic 27.

The page buffer 25 may be connected to the memory cell array 30 via a bit line BL. The page buffer 25 may serve as a write driver or a sense amplifier. Specifically, when performing a program operation, the page buffer 25 may serve as a write driver to apply a voltage according to data DATA to be stored in the memory cell array 30 to the bit line BL. When performing a read operation, the page buffer 25 may serve as a sense amplifier to detect data DATA stored in the memory cell array 30.

FIG. 2 to FIG. 6 are drawings for explaining coded GSL. Specifically, FIG. 2 is a circuit diagram for explaining one memory cell block of the memory cell array of FIG. 1. Each of the plurality of memory cell blocks BLK1 to BLKn included in the memory cell array 30 of FIG. 1 may have a structure identical to or similar to the memory cell block BLKa of FIG. 2.

Referring to FIG. 2, a memory cell block BLKa may include a plurality of bit lines (BL1, BL2, ..., BLm) extending in a first direction D1 and a plurality of NAND strings NS11 to NSam connected between a common source line CSL and the plurality of bit lines (BL1, BL2, ..., BLm). A plurality of NAND strings NS11 to NSam may be formed to each extend in a third direction D3 perpendicular to the first direction D1. Each of the plurality of NAND strings NS11 to NSam may include at least one string selection transistor SST, a plurality of memory cells MC1 to MCn, and a plurality of ground selection transistors GST1, GST2. Here, each NAND string is shown as including one string selection transistor SST, but each NAND string may include more string selection transistors. In addition, although FIG. 2 illustrates that there are two ground selection lines GSLO, GSL1, the number of ground selection lines may be two or more.

Among the memory cells MC1 to MCn of each of the plurality of NAND strings NS11 to NSam, memory cells located at the same height may share the same word line WL. For example, the first memory cells MC1 of each of the plurality of NAND strings NS11 to NSam may share the first word line WL1. The second memory cells MC2 of each of the plurality of NAND strings NS11 to NSam may share a second word line WL2. Similarly, the third to n-th memory cells MC3 to MCn of each of the plurality of NAND strings NS11 to NSam may share the third to n-th word lines WL3 to WLn, respectively.

The memory cells sharing the same word line may form a physical page. For example, a physical page may include memory cells arranged in an area where a word line (e.g., WL4) and the plurality of bit lines BL1 to BLm intersect. The nonvolatile memory device having a structure such as that of FIG. 2 may perform erasure in block units, and may perform program operations and read operations in physical page units corresponding to each word line WL1 to WLn.

In some embodiments, each of the plurality of NAND strings NS11 to NSam may include a plurality of ground selection transistors GSTs. The ground selection transistor GST may be connected to the corresponding ground selection line GSL and may be connected to the common source line CSL. In some embodiments, the plurality of ground selection transistors GSTs may be programmed to have different predetermined threshold voltage distributions. The first ground selection line GSLO and the second ground selection line GSL1 may be connected to transistors having different threshold voltage distributions.

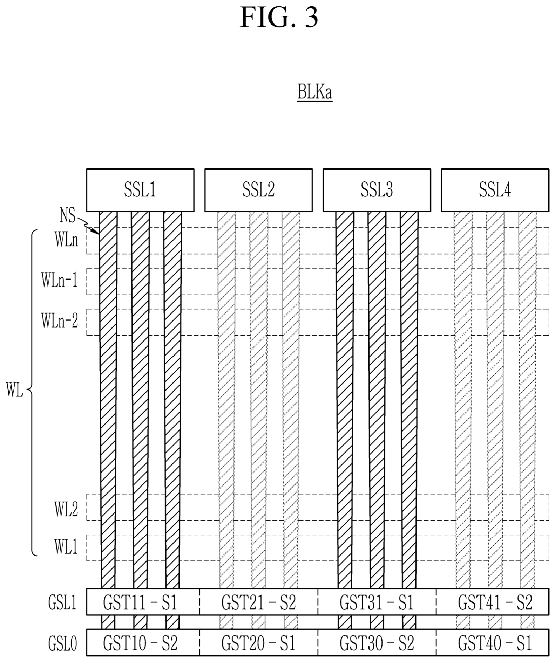

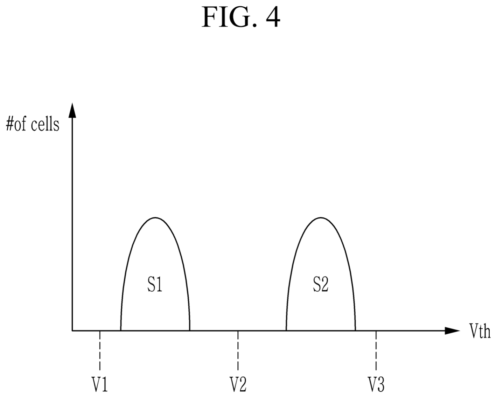

FIG. 3 is a diagram of a memory cell block of FIG. 2. FIG. 4 is a diagram showing the threshold voltage distribution of ground selection transistors according to some embodiments. Additionally, for convenience of explanation, only the first to fourth string selection lines SSL1 to SSL4 are illustrated in FIG. 3.

Referring to FIG. 3, the memory cell block BLKa may include the first to fourth string selection lines SSL1 to SSL4, and the first to fourth string selection lines SSL1 to SSL4 may be physically separated. The plurality of NAND strings NS may be connected to each of the first to fourth string selection lines SSL1 to SSL4.

In some embodiments, the ground selection lines GSL0, GSL1 may be arranged in common with the first to fourth string selection lines SSL1 to SSL4. In some embodiments, the ground selection lines GSL0, GSL1 may be commonly connected to a plurality of ground selection transistors GST within a plurality of NAND strings NS that are connected to the first to fourth string selection lines SSL1 to SSL4. For example, a first ground selection line GSL0 may be commonly connected to a plurality of ground selection transistors GST10 in a plurality of NAND strings connected to a first string selection line SSL1, a plurality of ground selection transistors GST20 in a plurality of NAND strings connected to a second string selection line SSL2, a plurality of ground selection transistors GST30 in a plurality of NAND strings connected to a third string selection line SSL3, and a plurality of ground selection transistors GST40 in a plurality of NAND strings connected to a fourth string selection line SSL4. Additionally, the second ground selection line GSL1 may be commonly connected to a plurality of ground selection transistors GST11 in a plurality of NAND strings connected to the first string selection line SSL1, a plurality of ground selection transistors GST21 in a plurality of NAND strings connected to the second string selection line SSL2, a plurality of ground selection transistors GST31 in a plurality of NAND strings connected to the third string selection line SSL3, and a plurality of ground selection transistors GST41 in a plurality of NAND strings connected to the fourth string selection line SSL4.

In some embodiments, the control logic 27 (of FIG. 1) may program the plurality of ground selection transistors to have predetermined threshold voltages. Referring also to FIG. 4, the control logic 27 may program a plurality of ground selection transistors such that each ground selection transistor is within a first threshold voltage distribution S1 or a second threshold voltage distribution S2 that does not overlap the first threshold voltage distribution S1. The first threshold voltage distribution S1 may mean a threshold voltage distribution greater than or equal to a first voltage level V1 and less than a second voltage level V2, and the second threshold voltage distribution S2 may mean a threshold voltage distribution greater than or equal to a second voltage level V2 and less than a third voltage level V3.

In some embodiments, the ground selection lines GSL0, GSL1 may be connected to ground selection transistors having different threshold voltage distributions. For example, the first ground selection line GSL0 may be connected to ground selection transistors GST20, GST40 having a first threshold voltage distribution S1 and ground selection transistors GST10, GST30 having a second threshold voltage distribution S2. Additionally, the second ground selection line GSL1 may be connected to ground selection transistors GST11, GST31 having a first threshold voltage distribution S1 and ground selection transistors GST21, GST41 having a second threshold voltage distribution S2.

In some embodiments, ground selection transistors connected to the same string selection line and connected to the same ground selection line may have the same threshold voltage distribution. For example, ground selection transistors GST10 connected to the first string selection line SSL1 and connected to the first ground selection line GSL0 may have a second threshold voltage distribution S2, and ground selection transistors GST11 connected to the first string selection line SSL1 and connected to the second ground selection line GSL1 may have a first threshold voltage distribution S1. Additionally, the ground selection transistors GST20 connected to the second string selection line SSL2 and connected to the first ground selection line GSL0 may have a first threshold voltage distribution S1, and the ground selection transistors GST21 connected to the second string selection line SSL2 and connected to the second ground selection line GSL1 may have a second threshold voltage distribution S2.

In some embodiments, the control logic 27 may apply different voltages to the ground selection lines GSL0, GSL1. The control logic 27 may apply different voltages to the ground selection lines GSL0, GSL1 to control the connection of the selected string selection line and the common source line. The control logic 27 may control the connection of the common source line CSL and the string selection line SSL by applying different voltages to the ground selection lines GSL0, GSL1. Referring to FIG. 4 together with FIGS. 2 and 3, when a voltage of a second voltage level V2 is applied to a transistor having a threshold voltage within a first threshold voltage distribution S1, the transistor may be turned on. On the other hand, when a voltage of the second voltage level V2 is applied to a transistor having a threshold voltage within a second threshold voltage distribution S2, the transistor may be turned off. Referring to FIG. 3, a voltage of a third voltage level V3 that may turn on all ground selection transistors connected to the first ground selection line GSL0 may be applied to the first ground selection line GSL0, and a voltage of a second voltage level V2 may be applied to the second ground selection line GSL1. Accordingly, among the transistors connected to the second ground selection line GSL1, the transistors having threshold voltages within the first threshold voltage distribution S1 may be turned on, but the transistors having threshold voltages within the second threshold voltage distribution S2 may be turned off. Accordingly, string selection transistors connected to the first string selection line SSL1 and string selection transistors connected to the third string selection line SSL3 may be electrically connected to the common source line CSL, but string selection transistors connected to each of the second string selection line SSL2 and the fourth string selection line SSL4 may be electrically separated or disconnected from the common source line CSL. The NAND strings connected to the first string selection line SSL1 and the third string selection line SSL3 may be electrically connected to the common source line CSL, but the NAND strings connected to the second string selection line SSL2 and the fourth string selection line SSL4 may not be electrically connected to the common source line CSL. It should be noted that the threshold voltages of the ground selection transistors and the voltages applied to the ground selection lines described herein are examples and are not limited thereto.

In some embodiments, the control logic 27 may control the ground selection transistors connected to the ground selection lines GSL0, GSL1 by controlling the row decoder 23 (of FIG. 1) to apply one of the first voltage level V1, the second voltage level V2, and the third voltage level V3 to the ground selection lines GSL0, GSL1.

A read operation of the nonvolatile memory device 10 (of FIG. 1) may be performed in units of physical pages formed in a memory cell block BLKa. In some embodiments, the size of a physical page corresponding to each word line WL0 to WLn may be flexible by controlling the voltage levels applied to the ground selection lines GSLs by the control logic 27. For example, when the nonvolatile memory device 10 performs a read operation on memory cells connected to a second word line WL1 and arranged in an area where a plurality of bit lines BL1 to BLm intersect, the nonvolatile memory device 10 may read data stored in memory cells within a subset of NAND strings (e.g., a NAND string connected to the first string selection line (SSL1) and the third string selection line SSL3) connected to a common source line among a plurality of NAND strings (e.g., the plurality of NAND strings including those connected to a the first string selection line (SSL1), the second string selection line SSL2, the third string selection line SSL3, and the fourth string selection line SSL4). Depending on the control of the control logic 27, the size of the physical page may be set to a first size (e.g., 8 KB). The control logic 27 may control the electrical connection between the common source line and memory cells within the NAND strings by controlling the voltage levels applied to the ground selection lines GSLs, and may determine the size of the physical page within the memory cell block BLKa.

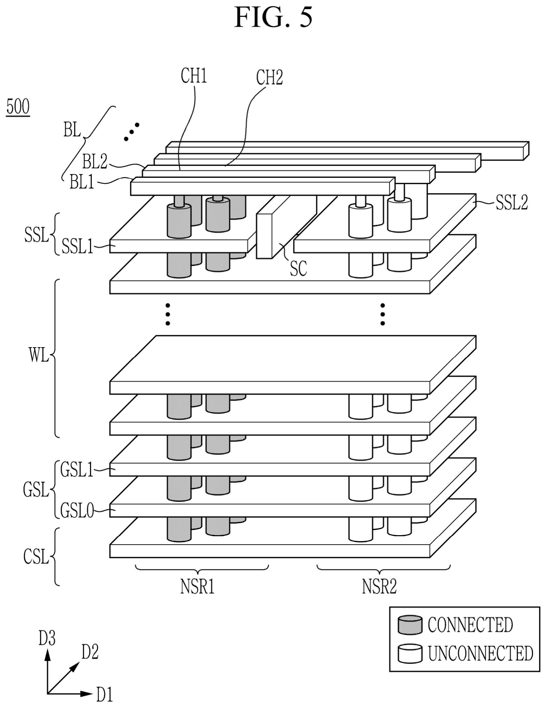

FIG. 5 is a perspective view of a memory cell block according to some embodiments. For convenience of explanation, only some NAND strings (NAND strings connected to the first string selection line SSL1 and the second string selection line SSL2) within a memory cell block are illustrated here, and FIG. 5 may be explained with reference to FIG. 2 and FIG. 3.

Referring to FIG. 5, a memory cell block 500 may include a plurality of bit lines BL, a plurality of string selection lines SSL, a plurality of channels CH, a plurality of word lines WL, a plurality of ground selection lines GSL, and a common source line CSL. Additionally, the plurality of string selection lines SSL may be cut by a string selection line cut region SC.

Each of the plurality of channels CH (CH1, CH2) is connected between and extends between a respective bit line of the plurality of bit lines BL and a common source line CSL, and may include at least one string selection transistor, a plurality of memory cells, and a plurality of ground selection transistors. Each of the plurality of channels CH may correspond to one of the plurality of NAND strings NS11 to NSam (of FIG. 2). For example, a first channel CH1 connected between a first bit line BL1 and a common source line CSL and connected to a first string selection line SSL1 may correspond to a NAND string NS11 (of FIG. 2), and a second channel CH2 connected between a second bit line BL2 and a common source line CSL and connected to the first string selection line SSL1 may correspond to a NAND string NS12 (of FIG. 2).

In some embodiments, the memory cell block 500 may include a plurality of NAND string regions NSRs. For example, the first NAND string region NSR1 may include a plurality of NAND strings connected to the first string selection line SSL1, and the second NAND string region NSR2 may include a plurality of NAND strings connected to the second string selection line SSL2. The first NAND string region NSR1 may include a plurality of channels corresponding to a plurality of NAND strings connected to the first string selection line SSL1, and the second NAND string region NSR2 may include a plurality of channels corresponding to a plurality of NAND strings connected to the second string selection line SSL2.

As described above with reference to FIG. 3, the connection between string select transistors SST of each string selection line SSL and the common source line CSL may be controlled according to the voltage level applied to the ground selection line GSL. The connection between the channel CH of each NAND string region and the common source line CSL may be controlled depending on the voltage level applied to the ground selection line GSL. For example, depending on the voltage level applied to the first ground selection line GSLO and the second ground selection line GSL1, the ground selection transistors of the first NAND string region NSR1 may be turned on, and the channels of the first NAND string region NSR1 may be electrically connected to the common source line CSL. Additionally, depending on the voltage levels applied to the first ground selection line GSL0 and the second ground selection line GSL1, some of the ground selection transistors of the second NAND string region NSR2 may be turned off, and the channels of the second NAND string region NSR2 may not be electrically connected to the common source line CSL.

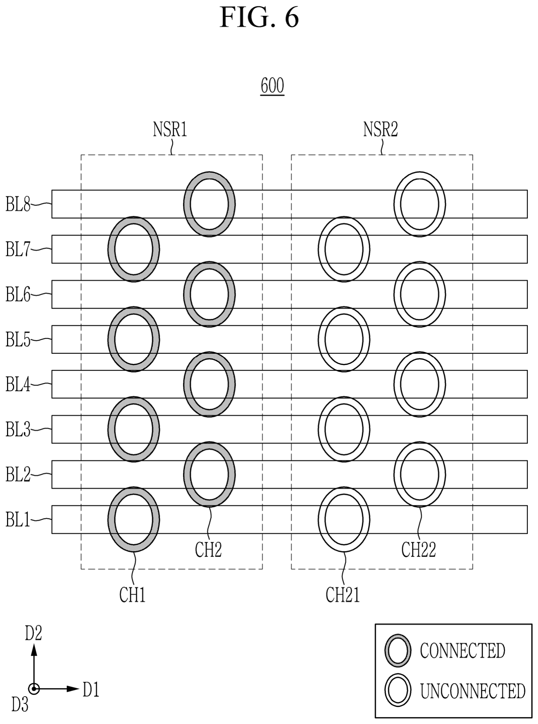

FIG. 6 is a plan view of a memory cell block according to some embodiments. Specifically, FIG. 6 is a cross-sectional view of the memory cell block of FIG. 5 cut in the first direction D1.

Referring to FIG. 6, a memory cell block 600 according to some embodiments may include a first NAND string region NSR1 and a second NAND string region NSR2. Each string region may include a plurality of channels CH, and each of the plurality of channels may be connected to a corresponding bit line BL. For example, a first channel CH1 within a first NAND string region NSR1 may be connected to a first bit line BL1, and a second channel CH2 within the first NAND string region NSR1 may be connected to a second bit line BL2. Additionally, a first channel CH21 within the second NAND string region NSR2 may be connected to a first bit line BL1, and a second channel CH22 within the second NAND string region NSR2 may be connected to a second bit line BL2. In this way, each channel within each NAND string region may be connected to a corresponding bit line.

As described with reference to FIG. 5, the connection between the channel CH of each NAND string region and the common source line CSL may be controlled according to the voltage level applied to the ground selection line GSL. For example, depending on the voltage level applied to the first ground selection line GSL0 and the second ground selection line GSL1, the ground selection transistors of the first NAND string region NSR1 may be turned on, and the channels of the first NAND string region NSR1 may be electrically connected to the common source line CSL. Additionally, depending on the voltage levels applied to the first ground selection line GSL0 and the second ground selection line GSL1, some of the ground selection transistors of the second NAND string region NSR2 may be turned off, and the channels of the second NAND string region NSR2 may not be electrically connected to the common source line CSL.

A nonvolatile memory device according to some embodiments may control the connection of a string selection line and a common source line through a coded GSL structure.

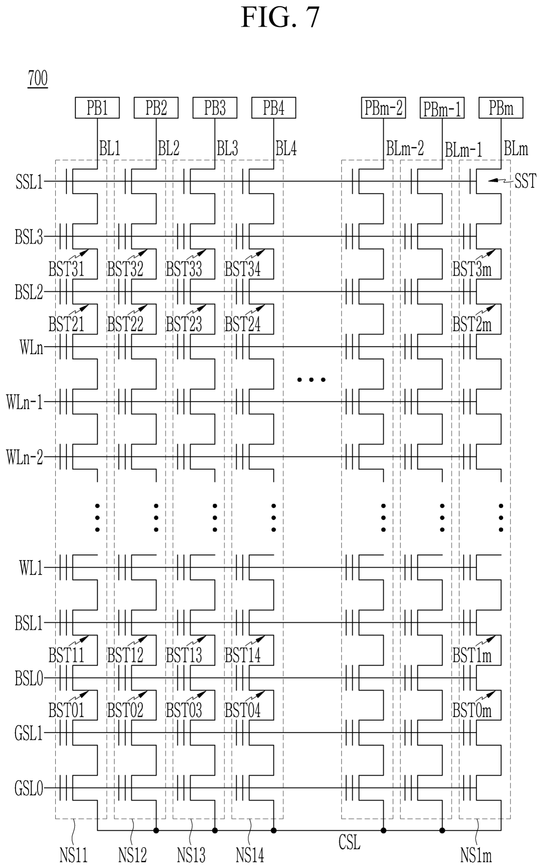

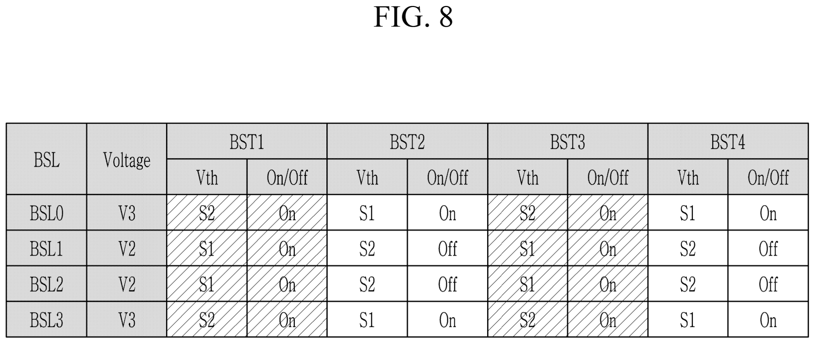

FIG. 7 is a diagram showing the structure of a memory cell block according to some embodiments. FIG. 8 is a table showing the voltage applied to the bit line selection line and the states of the bit line selection transistors according to the voltage applied to the bit line selection line.

In some embodiments, a memory cell block 700 may include a plurality of NAND strings NS11 to NS1m. Each of the plurality of NAND strings NS11 to NS1m may be connected to a first string selection line SSL1, a plurality of word lines WL1 to WLn, a plurality of ground selection lines GSL0, GSL1, and a common source line CSL. Each of the plurality of NAND strings NS11 to NS1m may be connected to a corresponding bit line BL1 to BLm. As described above in FIG. 2 to FIG. 6, the structure of the ground selection lines of FIG. 7 is a coded GSL structure, and a selected string selection line SSL1 among a plurality of string selection lines may be electrically connected to a common source line CSL depending on the voltage levels applied to the ground selection lines GSLs. Depending on the voltage levels applied to the ground selection lines GSLs, the string selection transistors SST connected to the selected string selection line SSL1 may be electrically connected to the common source line CSL.

In some embodiments, each of the plurality of NAND strings NS11 to NS1m may be further connected to a plurality of bit line selection lines BSL0 to BSL3. Each of the plurality of NAND strings NS11 to NS1m may further include the plurality of bit line selection transistors BSTs. Some bit line selection lines BSL0, BSL1 of the plurality of bit line selection lines BSL0 to BSL3 may be located between the lowest word line WL1 and the ground selection line GSL1. Some bit line selection lines BSL2, BSL3 of the plurality of bit line selection lines BSL0 to BSL3 may be located between the highest word line WLn and the string selection line SSL1. Some transistors BST01 to BST1m of the plurality of bit line selection transistors BST may be located between a memory cell connected to the lowest word line WL1 and a ground selection transistor connected to a ground selection line GSL1. Some transistors BST21 to BST3m of the plurality of bit line selection transistors BST may be located between a memory cell connected to the top word line WLn and a string selection transistor SST connected to a string selection line SSL1.

In some embodiments, the control logic 27 (of FIG. 1) may separate the plurality of bit lines BL0 to BLm into the plurality of groups. For example, the control logic 27 may determine the bit lines spaced apart at a predetermined interval among the plurality of bit lines BL0 to BLm into the plurality of groups. For example, the control logic 27 may determine odd bit lines BL1, BL3, ... among a plurality of bit lines BL0 to BLm as a first bit line group, and may determine even bit lines BL2, BL4, ... among a plurality of bit lines BL0 to BLm as a second bit line group.

In some embodiments, a plurality of bit line selection transistors BSTs connected to a plurality of bit line selection lines BSL0 to BSL3 may be programmed to have threshold voltages within a predetermined threshold voltage distribution. In some embodiments, the control logic 27 may program the plurality of bit line selection transistors to have a predetermined threshold voltage within a particular threshold voltage distribution. For example, the control logic 27 may program a plurality of bit line selection transistors BST connected to a plurality of bit line selection lines BSL0 to BSL3 to have a first threshold voltage distribution or a second threshold voltage distribution.

In some embodiments, a plurality of bit line selection transistors BSTs connected to the same bit line selection line and corresponding to the same bit line group may have threshold voltages within the same threshold voltage distribution as each other. In some embodiments, the control logic 27 may program a plurality of bit line selection transistors BST connected to the same bit line selection line and corresponding to the same bit line group so that the bit line selection transistors BST have threshold voltages within the same threshold voltage distribution as each other. For example, among a plurality of bit line selection transistors connected to the same bit line selection line, bit line selection transistors connected to odd-numbered bit lines may have threshold voltages within the same threshold voltage distribution. Alternatively, bit line selection transistors connected to even-numbered bit lines among a plurality of bit line selection transistors connected to the same bit line selection line may have threshold voltages within the same threshold voltage distribution. Referring to FIG. 8 together with FIG. 7, transistors BST1, BST3 connected to the same bit line selection line (e.g., BSL0) and corresponding to odd bit lines BL1, BL3 may have (e.g., may be programmed to have) threshold voltages within the same threshold voltage distribution S2, and transistors BST2, BST4 connected to the same bit line selection line (e.g., BSL0) and corresponding to even bit lines BL2, BL4 may have (e.g., may be programmed to have) threshold voltages within the same threshold voltage distribution S1. In some embodiments, the plurality of bit line selection transistors BSTs connected to the same bit line selection line and corresponding to different bit line groups may have different threshold voltage distributions.

In some embodiments, a plurality of bit line selection lines BSL0 to BSL3 may be connected to a plurality of bit line selection transistors BST having different threshold voltage distributions. Referring to FIG. 8 together with FIG. 7, the first bit line selection line BSL0 may be connected to bit line selection transistors BST01 (BST1), BST03 (BST3) having a second threshold voltage distribution S2 and bit line selection transistors BST02 (BST2), BST04 (BST4) having a first threshold voltage distribution S1. The second bit line selection line BSL1 may be connected to bit line selection transistors BST11, BST13 having a first threshold voltage distribution S1 and bit line selection transistors BST12, BST14 having a second threshold voltage distribution S2. The third bit line selection line BSL2 may be connected to bit line selection transistors BST21, BST23 having a first threshold voltage distribution S1 and bit line selection transistors BST22, BST24 having a second threshold voltage distribution S2. The fourth bit line selection line BSL3 may be connected to bit line selection transistors BST31, BST33 having a second threshold voltage distribution S2 and bit line selection transistors BST32, BST34 having a first threshold voltage distribution S1.

In some embodiments, the control logic 27 may apply various voltages to the bit line selection lines BSL0 to BSL3 to control the connection of a selected bit line among a plurality of bit lines BL1 to BLm and a NAND string. For example, depending on the voltage applied to the bit line selection lines BSL0 to BSL3, the selected bit line may be electrically connected to the NAND string and the common source line CSL, and the remaining bit lines may not be electrically connected to the NAND string and the common source line CSL. A detailed explanation of this is provided with reference to FIG. 8.

In some embodiments, the control logic 27 may control voltage levels applied to bit line selection lines BSL0 to BSL3 when performing a read operation. The control logic 27 may control the row decoder 23 (of FIG. 1) so that one of the first voltage level V1, the second voltage level V2, and the third voltage level V3 is applied to the bit line selection lines BSL0 to BSL3. Control logic 27 may control bit line selection transistors BST connected to bit line selection lines BSL0 to BSL3 by controlling voltage levels applied to bit line selection lines BSL0 to BSL3.

In some embodiments, the control logic 27 may determine some of the bit lines BL1 to BLm as the selected bit lines. For example, the control logic 27 may determine an odd-numbered bit line BL1, BL3, ... among a plurality of bit lines BL1 to BLm as the selected bit line. The control logic 27 may apply different voltages to the bit line selection lines BSLO to BSL3 to connect odd bit lines BL1, BL3, ... to the NAND string and the common source line CSL.

Referring to FIG. 7 together with FIG. 8, the control logic 27 may apply a voltage of a third voltage level V3 that may turn on all bit line selection transistors connected to the first bit line selection line BSL0 and the fourth bit line selection line BSL3 to the first bit line selection line BSL0 and the fourth bit line selection line BSL3, and may apply a voltage of a second voltage level V2 to the second bit line selection line BSL1 and the third bit line selection line BSL2. Accordingly, among the transistors connected to the second bit line selection line BSL1 and the third bit line selection line BSL2, the transistors having the first threshold voltage distribution S1 may be turned on, but the transistors having the second threshold voltage distribution S2 may be turned off. When a voltage of the second voltage level V2 is applied to the second bit line selection line BSL1, the bit line selection transistors BST11, BST13 corresponding to the selected bit line (odd bit line) among the transistors connected to the second bit line selection line BSL1 may be turned on, and the bit line selection transistors BST12, BST14 corresponding to the unselected bit line (even bit line) may be turned off. In addition, as a voltage of the second voltage level V2 is applied to the third bit line selection line BSL2, bit line selection transistors BST21, BST23 corresponding to a selected bit line (odd bit line) among the transistors connected to the third bit line selection line BSL2 may be turned on, and bit line selection transistors BST22, BST24 corresponding to an unselected bit line (even bit line) may be turned off.

In some embodiments, the NAND strings NS11, NS13, ... corresponding to the selected bit line (odd-numbered bit line) may include bit line select transistors that are turned on according to voltages applied to the plurality of bit line selection lines BSL0 to BSL3. Each of the NAND strings NS12, NS14, ... corresponding to an unselected bit line (an even-numbered bit line) may include at least one bit line selection transistor that is turned off according to a voltage applied to a plurality of bit line selection lines BSL0 to BSL3. For example, a NAND string NS12 corresponding to an unselected bit line may include at least one bit line selection transistor BST12, BST22 that is turned off according to a voltage applied to a plurality of bit line selection lines BSL0 to BSL3.

In some embodiments, the control logic 27 may electrically connect a NAND string corresponding to a selected bit line among a plurality of NAND strings NS11 to NS1m corresponding to a plurality of bit lines BL1 to BLm to a common source line CSL. For example, the control logic 27 may electrically connect a plurality of NAND strings NS11, NS13, ... corresponding to odd bit lines BL1, BL3, ... among a plurality of NAND strings NS11 to NS1m corresponding to a plurality of bit lines BL1 to BLm to a common source line CSL. In some embodiments, the control logic 27 may electrically insulate a NAND string corresponding to an unselected bit line from a common source line CSL among a plurality of NAND strings NS11 to NS1m corresponding to a plurality of bit lines BL1 to BLm. For example, the control logic 27 may electrically insulate the plurality of NAND strings NS12, NS14, ... corresponding to even bit lines BL2, BL4, ... from the common source line CSL among the plurality of NAND strings NS11 to NS1m corresponding to the plurality of bit lines BL1 to BLm. Meanwhile, the threshold voltages of the bit line selection transistors and the voltages applied to the bit line selection lines described herein are examples and are not limited thereto.

In some embodiments, each bit line BL1 to BLm may be connected to a corresponding page buffer PB1 to PBm. During a read operation, the memory cell block 700 (see FIG. 7) may output data stored in the memory cell to the page buffer PB1 to PBm in response to at least one voltage supplied to the word line WL1 to WLn. In some embodiments, the control logic 27 may activate only the page buffer connected to a selected bit line among the plurality of bit lines BL1 to BLm. For example, only the page buffers PB1, PB3, ... connected to odd bit lines BL1, BL3, ... among the plurality of bit lines BL1 to BLm may be activated, and the remaining page buffers may be deactivated. However, the operation of the control logic 27 and the page buffer according to the present disclosure is not limited thereto.

In some embodiments, the size of a physical page corresponding to each word line WL0 to WLn may be flexible by controlling the voltage levels applied to the bit line selection lines BL0 to BL3 by the control logic 27. For example, when a read operation is performed on memory cells connected to the second word line WL1 of the memory cell block 700 and arranged in an area where a plurality of bit lines BL1 to BLm intersect, the control logic 27 may read data stored in memory cells within a selected bit line (e.g., an odd-numbered bit line) among a plurality of NAND strings of the memory cell block 700 and a NAND string (e.g., NS11, NS13, ...) connected to a common source line CSL. Depending on the control of the control logic 27, the size of the physical page may be set to a second size (e.g., 4 KB). That is, the control logic 27 may control the electrical connection of the bit line and common source line with the NAND string by controlling the voltage levels applied to the bit line selection lines BL0 to BL3, and may set the size of the physical page within the memory cell block BLKa in various ways.

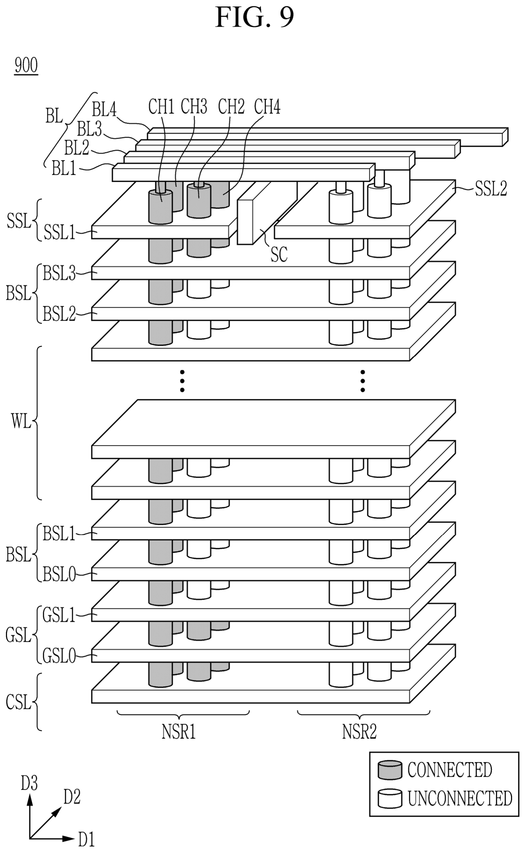

FIG. 9 is a perspective view of a memory cell block according to some embodiments. For convenience of explanation, only some NAND strings within a memory cell block are illustrated here, and FIG. 9 may be explained with reference to FIG. 7. Additionally, any explanation that overlaps with FIG. 5 is omitted here.

Referring to FIG. 9, a memory cell block 900 may include a plurality of bit lines BL, a string selection line SSL, a plurality of channels CH, a word line WL, a ground selection line GSL, a bit line selection line BSL, and a common source line CSL. Additionally, the string selection line SSL may be cut by a string selection line cut region SC.

In some embodiments, each NAND string region NSR may include the plurality of channels, and depending on the voltage level applied to the ground selection line GSL, the channels within the second NAND string region NSR2 may be electrically disconnected from the common source line CSL.

In some embodiments, the connection of a bit line and common source line CSL and a channel CH within a NAND string region NSR may be controlled according to the voltage applied to the bit line selection lines BSL0 to BSL3. For example, depending on the voltage applied to the bit line selection lines BSL0 to BSL3 during operation, odd-numbered bit lines BL1, BL3 and common source lines CSL and channels CH1, CH3 within the first NAND string region NSR1 may be electrically connected. Depending on the voltage applied to the bit line selection lines BSL0 to BSL3 during operation, the even bit lines BL2, BL4 and the common source line CSL and channels CH2, CH4 within the first NAND string region NSR1 may not be electrically connected. Accordingly, the capacitance between the word line and the channel may be reduced, thereby improving the performance of the nonvolatile memory device including the memory cell block 900 and reducing power consumption.

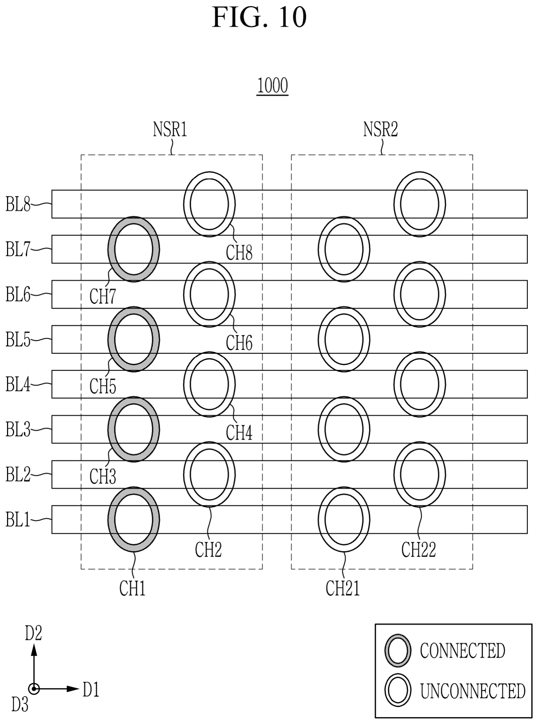

FIG. 10 is a plan view of a memory cell block according to some embodiments. Specifically, FIG. 10 is a cross-sectional view of the memory cell block 900 of FIG. 9 cut in the first direction D1.

Referring to FIG. 10, a memory cell block 1000 according to some embodiments may include a first NAND string region NSR1 and a second NAND string region NSR2. Each string region may include the plurality of channels CH, and each of the plurality of channels may correspond to a bit line BL. For example, a first channel CH1 in a first NAND string region NSR1 may correspond to a first bit line BL1, and a second channel CH2 in a first NAND string region NSR1 may correspond to a second bit line BL2. Additionally, the first channel CH21 within the second NAND string region NSR2 may correspond to the first bit line BL1, and the second channel CH22 within the second NAND string region NSR2 may correspond to the second bit line BL2. In this way, each channel within each NAND string region may correspond to a respective bit line.

In some embodiments, the connection of a channel CH of each NAND string region to a common source line CSL may be controlled depending on the voltage level applied to a ground selection line GSL. For example, depending on the voltage level applied to the first ground selection line GSL0 and the second ground selection line GSL1, the ground selection transistors of the first NAND string region NSR1 may be turned on, and the channels of the first NAND string region NSR1 may be electrically connected to the common source line CSL. Additionally, depending on the voltage levels applied to the first ground selection line GSL0 and the second ground selection line GSL1, some of the ground selection transistors of the second NAND string region NSR2 may be turned off, and the channels of the second NAND string region NSR2 may not be electrically connected to the common source line CSL.

In some embodiments, the connection of each bit line and common source line CSL to a channel CH within each NAND string region may be controlled based on the voltage level applied to the bit line selection line BSL. For example, depending on the voltage applied to the bit line selection lines BSL0 to BSL3, the selected bit line (e.g., odd-numbered bit lines (BL1, BL3, BL5, BL7)) and the common source line CSL NSR1 may be electrically connected to the channels CH1, CH3, CH5, CH7 within the first NAND string region. Depending on the voltage applied to the bit line selection lines BSL0 to BSL3, unselected bit lines (e.g., even-numbered bit lines BL2, BL4, BL6, BL8)) and the common source line CSL may not be electrically connected to channels CH2, CH4, CH6, CH8 within the first NAND string region NSR1.

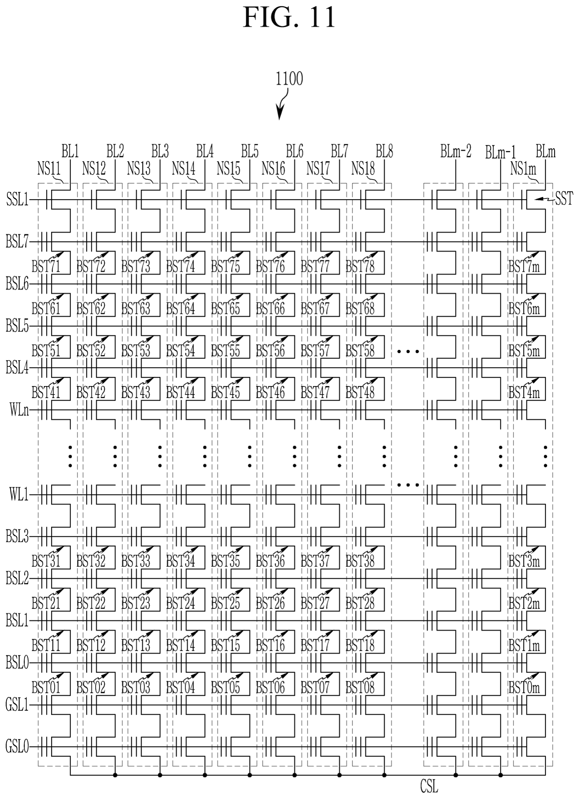

FIG. 11 is a diagram showing the structure of a memory cell block according to some embodiments.

In some embodiments, a memory cell block 1100 may include a plurality of NAND strings NS11 to NS1m. Each of the plurality of NAND strings NS11 to NS1m may be connected to a first string selection line SSL1, a plurality of word lines WL1 to WLn, a plurality of ground selection lines GSL0, GSL1, and a common source line CSL. Each of the plurality of NAND strings NS11 to NS1m may be connected to a corresponding bit line BL1 to BLm. As described above in FIGS. 2 to 6, the structure of the ground selection lines of FIG. 11 is a coded GSL structure, and a selected string selection line SSL1 among a plurality of string selection lines may be electrically connected to a common source line CSL depending on the voltage levels applied to the ground selection lines GSLs. Depending on the voltage levels applied to the ground selection lines GSLs, the string selection transistors SST connected to the selected string selection line SSL1 may be electrically connected to the common source line CSL.

In some embodiments, each of the plurality of NAND strings NS11 to NS1m may be further connected to one of a plurality of bit line selection lines BSL0 to BSL7. Each of the plurality of NAND strings NS11 to NS1m may further include the plurality of bit line selection transistors BSTs. Some of the plurality of bit line selection lines BSL0 to BSL7 may be located between the lowest word line WL1 and the ground selection line GSL1. Some of the plurality of bit line selection lines BSL0 to BSL7 BSL4 to BSL7 may be located between the highest word line WLn and the string selection line SSL1. Some of the plurality of bit line selection transistors BST BST01 to BST3m may be located between the memory cell connected to the lowest word line WL1 and the ground selection transistor connected to the ground selection line GSL1. Some of the plurality of bit line selection transistors BST BST41 to BST7m may be located between a memory cell connected to the highest word line WLn and a string selection transistor SST connected to a string selection line SSL1.

In some embodiments, the control logic 27 (of FIG. 1) may separate the plurality of bit lines BL0 to BLm into the plurality of groups. For example, the control logic 27 may determine the bit lines spaced apart at a predetermined interval among the plurality of bit lines BL0 to BLm into the plurality of groups. For example, the control logic 27 may determine bit lines BL1, BL5, ... among the plurality of bit lines BL0 to BLm as a first bit line group, bit lines BL2, BL6, ... among the plurality of bit lines BL0 to BLm as a second bit line group, bit lines BL3, BL7, ... among the plurality of bit lines BL0 to BLm as a third bit line group, and bit lines BL4, BL8, ... among the plurality of bit lines BL0 to BLm as a fourth bit line group.

In some embodiments, a plurality of bit line selection transistors BSTs connected to a plurality of bit line selection lines BSL0 to BSL7 may be programmed to have a predetermined threshold voltage distribution. In some embodiments, the control logic 27 may program the plurality of bit line selection transistors to have a predetermined threshold voltage. For example, the control logic 27 may program a plurality of bit line selection transistors BST connected to a plurality of bit line selection lines BSL0 to BSL7 to have a first threshold voltage distribution or a second threshold voltage distribution.

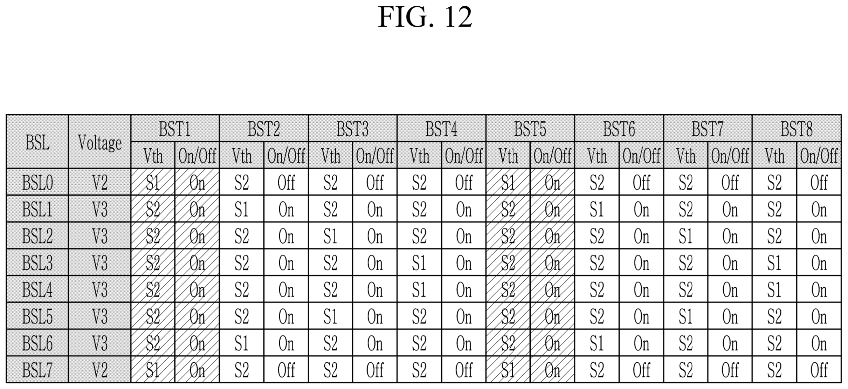

In some embodiments, a plurality of bit line selection transistors BSTs connected to the same bit line selection line and corresponding to the same bit line group may have threshold voltages within the same threshold voltage distribution. In some embodiments, the control logic 27 may program a plurality of bit line selection transistors BST connected to the same bit line selection line and corresponding to the same bit line group so that the bit line selection transistors BST have threshold voltages within the same threshold voltage distribution. For example, referring to FIG. 12, transistors BST1, BST5 connected to the same bit line selection line and corresponding to the first bit line group BL1, BL5 may have threshold voltages within the same threshold voltage distribution, transistors BST2, BST6 connected to the substantially the same bit line selection line and corresponding to the second bit line group BL2, BL6 may have threshold voltages within the same threshold voltage distribution, transistors BST3, BST7 connected to the same bit line selection line and corresponding to the third bit line group BL3, BL7 may have threshold voltages within the same threshold voltage distribution, and transistors BST4, BST8 connected to the same bit line selection line and corresponding to the fourth bit line group BL4, BL8 may have threshold voltages within the same threshold voltage distribution. In some embodiments, the plurality of bit line selection transistors BSTs connected to the same bit line selection line and corresponding to different bit line groups may have threshold voltages within different threshold voltage distributions.

In some embodiments, a plurality of bit line selection lines BSL0 to BSL7 may be connected to a plurality of bit line selection transistors BSTs having threshold voltages within different threshold voltage distributions. Referring to FIG. 12 together with FIG. 11, the first bit line selection line BSL0 may be connected to bit line selection transistors BST01, BST05 having threshold voltages within a first threshold voltage distribution S1 and bit line selection transistors BST02 to BST04, BST06 to BST08 having threshold voltages within a second threshold voltage distribution S2. The second bit line selection line BSL1 may be connected to bit line selection transistors BST12, BST16 having threshold voltages within a first threshold voltage distribution S1 and bit line selection transistors BST11, BST13 to BST15, BST17, BST18 having threshold voltages within a second threshold voltage distribution S2. The third bit line selection line BSL2 may be connected to bit line selection transistors BST23, BST27 having threshold voltages within a first threshold voltage distribution S1 and bit line selection transistors BST21, BST22, BST24 to BST26, BST28 having threshold voltages within a second threshold voltage distribution S2. The fourth bit line selection line BSL3 may be connected to bit line selection transistors BST34, BST38 having threshold voltages within a first threshold voltage distribution S1 and bit line selection transistors BST31 to BST33, BST35 to BST37 having threshold voltages within a second threshold voltage distribution S2.

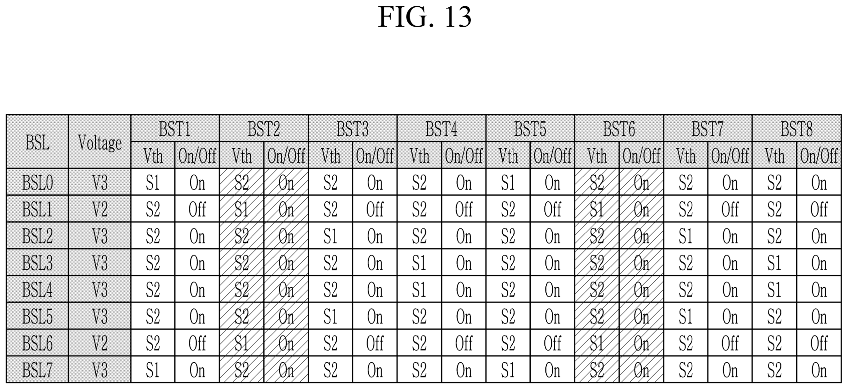

In some embodiments, the control logic 27 may apply various voltages to the bit line selection lines BSL0 to BSL7 to control the connection of a selected bit line among a plurality of bit lines BL1 to BLm and a NAND string. For example, depending on the voltage applied to the bit line selection lines BSL0 to BSL7, the selected bit line may be electrically connected to the NAND string and the common source line CSL, and the remaining bit lines may not be electrically connected to the NAND string and the common source line CSL. A detailed explanation of this is provided with reference to FIG. 12 and FIG. 13.

FIG 12 and FIG. 13 are tables showing the voltage applied to the bit line selection line and the states of the bit line selection transistors according to the voltage.

In some embodiments, the control logic 27 may control voltage levels applied to bit line selection lines BSL0 to BSL7 when performing a read operation. The control logic 27 may control the row decoder 23 (of FIG. 1) so that one of the first voltage level V1, the second voltage level V2, and the third voltage level V3 is applied to the bit line selection lines BSL0 to BSL7. Control logic 27 may control bit line selection transistors BST connected to bit line selection lines BSL0 to BSL7 by controlling voltage levels applied to bit line selection lines BSL0 to BSL7.

In some embodiments, the control logic 27 may determine some of the bit lines BL1 to BLm as the selected bit lines. For example, the control logic 27 may determine the first bit line group BL1, BL5, ... among the plurality of bit lines BL1 to BLm as the selected bit lines. The control logic 27 may apply different voltages to the bit line selection lines BSL0 to BSL7 to connect the first bit line group BL1, BL5, ... with the NAND string and the common source line CSL.

Referring to FIG. 11 together with FIG. 12, the control logic 27 may apply a voltage of a third voltage level V3 that may turn on all bit line selection transistors connected to the second bit line selection line BSL1 through the seventh bit line selection line BSL6, and may apply a voltage of a second voltage level V2 to the first bit line selection line BSL0 and the eighth bit line selection line BSL7. Accordingly, among the transistors connected to the first bit line selection line BSL0 and the eighth bit line selection line BSL7, the transistors BST01, BST05, BST71, BST75 having the first threshold voltage distribution S1 may be turned on, but the transistors having the second threshold voltage distribution S2 may be turned off. Therefore, when a voltage of the second voltage level V2 is applied to the first bit line selection line BSL0 and the eighth bit line selection line BSL7, among the transistors connected to the first bit line selection line BSL0 and the eighth bit line selection line BSL7, the bit line selection transistors BST01, BST05, BST71, BST75 corresponding to the first bit line group BL1, BL5 may be turned on, and corresponding bit line selection transistors corresponding to the remaining bit lines may be turned off.

In some embodiments, the NAND strings NS11, NS15, ... corresponding to the selected first bit line group BL1, BL5, ... may include bit line selection transistors that are turned on according to voltages applied to a plurality of bit line selection lines BSL0 to BSL7. Each of the NAND strings NS12, NS13, NS14, NS16, NS17, NS18, ... corresponding to an unselected bit line group (e.g., BL2, BL3, BL4, BL6, BL7, BL8, ...) may include at least one bit line selection transistor that is turned off according to a voltage applied to a plurality of bit line selection lines BSL0 to BSL7. For example, a NAND string NS12 corresponding to an unselected bit line may include at least one bit line selection transistor BST02, BST72 that is turned off in response to a voltage applied to a plurality of bit line selection lines BSL0 to BSL7, and a NAND string NS13 corresponding to an unselected bit line may include at least one bit line selection transistor BST03, BST73 that is turned off in response to a voltage applied to a plurality of bit line selection lines BSL0 to BSL7, etc.

In another embodiment, the control logic 27 may determine a second bit line group BL2, BL6, ... among a plurality of bit lines BL1 to BLm as the selected bit lines. The control logic 27 may apply different voltages to the bit line selection lines BSL0 to BSL7 to connect the second bit line group BL2, BL6, ... with the NAND string and the common source line CSL.

Referring to FIG. 11 and FIG. 13 together, the control logic 27 may apply a voltage of a third voltage level V3 capable of turning on all bit line selection transistors connected to the first bit line selection line BSL0, the third bit line selection line BSL2 to the sixth bit line selection line BSL5, and the eighth bit line selection line BSL7, and may apply a voltage of a second voltage level V2 to the second bit line selection line BSL1 and the seventh bit line selection line BSL6. Accordingly, among the transistors connected to the second bit line selection line BSL1 and the seventh bit line selection line BSL6, the transistors BST12, BST16, BST62, BST66 having threshold voltages within the first threshold voltage distribution S1 may be turned on, but the transistors having threshold voltages within the second threshold voltage distribution S2 may be turned off. For example, and referring to FIG. 13, when a voltage of the second voltage level V2 is applied to the second bit line selection line BSL1 and the seventh bit line selection line BSL6, among the transistors connected to the second bit line selection line BSL1 and the seventh bit line selection line BSL6, the bit line selection transistors BST2, BST6, BST61, BST66 corresponding to the second bit line group BL2, BL6 may be turned on, and the bit line selection transistors corresponding to the remaining bit lines may be turned off. The threshold voltages of the bit line selection transistors and the voltages applied to the bit line selection lines described herein are examples and are not limited thereto.

In some embodiments, the control logic 27 may electrically connect a NAND string corresponding to a selected bit line among a plurality of NAND strings NS11 to NS1m corresponding to a plurality of bit lines BL1 to BLm to a common source line CSL. For example, among a plurality of NAND strings NS11 to NS1m corresponding to a plurality of bit lines BL1 to BLm, a plurality of NAND strings NS11, NS15, ... corresponding to a selected bit line BL1, BL5, ... may be electrically connected to a common source line CSL. Alternatively, among the plurality of NAND strings NS11 to NS1m corresponding to the plurality of bit lines BL1 to BLm, the plurality of NAND strings NS12, NS16, ... corresponding to the selected bit lines BL2, BL6, ... may be electrically connected to the common source line CSL.

In some embodiments, the size of a physical page corresponding to each word line WL0 to WLn may be flexible by controlling the voltage levels applied to the bit line selection lines BL0 to BL3 by the control logic 27. For example, when a read operation is performed on memory cells connected to the second word line WL1 of the memory cell block 1100 and arranged in an area where a plurality of bit lines BL1 to BLm intersect, the control logic 27 may read data stored in memory cells within selected bit lines (e.g., BL1, BL5, ...) among a plurality of NAND strings of the memory cell block 1100 and NAND strings (e.g., NS11, NS15, ...) connected to a common source line CSL. Depending on the control of the control logic 27, the size of the physical page may be set to a third size (e.g., 2 KB). For example, the control logic 27 may control the electrical connection of the bit line and common source line with the NAND string by controlling the voltage levels applied to the bit line selection lines BSL0 to BSL7, and may set the size of the physical page within the memory cell block BLKa in various ways.

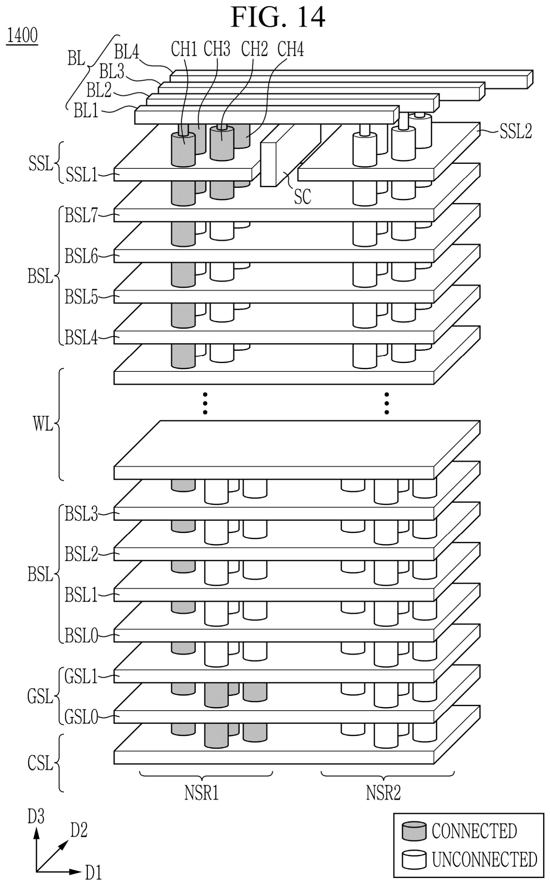

FIG. 14 is a perspective view of a memory cell block according to some embodiments. For convenience of explanation, only some NAND strings within a memory cell block are illustrated here, and FIG. 14 may be explained with reference to FIG. 11. Additionally, any description overlapping with FIG. 5 and FIG. 9 is omitted here.

In some embodiments, the connection of a bit line and common source line CSL and a channel CH within a NAND string region NSR may be controlled according to the voltage applied to the bit line selection lines BSL0 to BSL7. For example, depending on the voltage applied to the bit line selection lines BSL0 to BSL7, the selected bit lines BL1, BL5 and the common source line CSL and channels CH1, CH5 within the first NAND string region NSR1 may be electrically connected. Depending on the voltage applied to the bit line selection lines BSL0 to BSL7, the unselected bit lines BL2 to BL4 and the common source line CSL may not be electrically connected to the channels CH2 to CH4 within the first NAND string region NSR1. Accordingly, the capacitance between the word line and the channel may be reduced, thereby improving the performance of the nonvolatile memory device including the memory cell block 1400 and reducing power consumption.

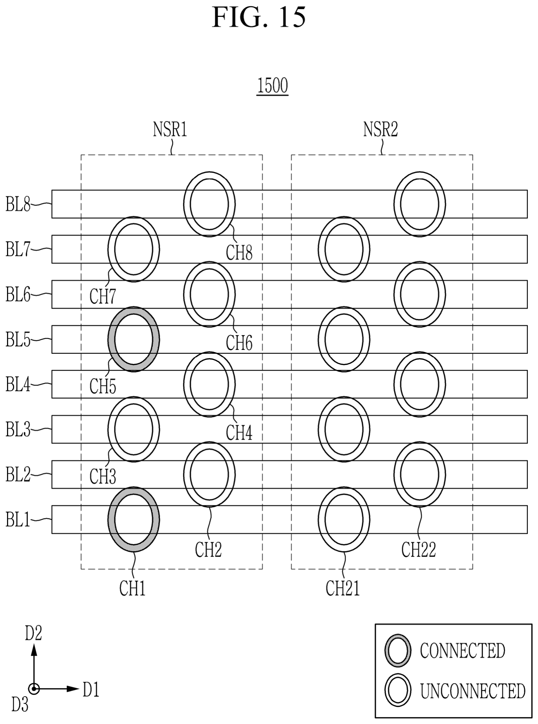

FIG. 15 is a plan view of a memory cell block according to some embodiments. Specifically, FIG. 15 is a cross-sectional view of the nonvolatile memory cell block 1400 of FIG. 14 cut in the first direction D1.

Referring to FIG. 15, a memory cell block 1500 according to some embodiments may include a first NAND string region NSR1 and a second NAND string region NSR2. Each string region may include the plurality of channels CH, and each of the plurality of channels may correspond to a bit line BL. For example, a first channel CH1 in a first NAND string region NSR1 may correspond to a first bit line BL1, and a second channel CH2 in a first NAND string region NSR1 may correspond to a second bit line BL2. Additionally, the first channel CH21 within the second NAND string region NSR2 may correspond to the first bit line BL1, and the second channel CH22 within the second NAND string region NSR2 may correspond to the second bit line BL2. In this way, each channel within each NAND string region may correspond to a respective bit line.

In some embodiments, the connection of a channel CH of each NAND string region to a common source line CSL may be controlled depending on the voltage level applied to a ground selection line GSL. For example, depending on the voltage level applied to the first ground selection line GSL0 and the second ground selection line GSL1, the ground selection transistors of the first NAND string region NSR1 may be turned on, and the channels of the first NAND string region NSR1 may be electrically connected to the common source line CSL. Additionally, depending on the voltage levels applied to the first ground selection line GSL0 and the second ground selection line GSL1, some of the ground selection transistors of the second NAND string region NSR2 may be turned off, and the channels of the second NAND string region NSR2 may not be electrically connected to the common source line CSL.

In some embodiments, the connection of each bit line and common source line CSL to a channel CH within each NAND string region may be further controlled based on the voltage level applied to the bit line selection line BSL. For example, depending on the voltage applied to the bit line selection lines BSL0 to BSL7, the selected bit lines (e.g., BL1, BL5) and the common source line CSL and channels CH1, CH5 within the first NAND string region NSR1 may be electrically connected. Depending on the voltage applied to the bit line selection lines BSL0 to BSL7, unselected bit lines (e.g., BL2 to BL4, BL6 to BL8) and common source lines CSL and channels (CH2 to CH4, CH6 to CH8) within the first NAND string region NSR1 may not be electrically connected.

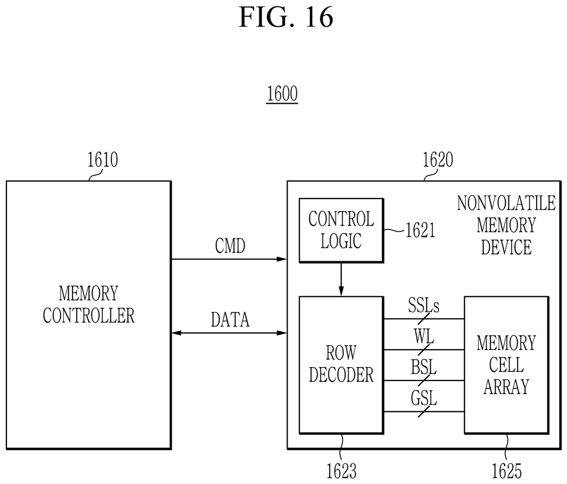

FIG. 16 is a block diagram of a storage device according to some embodiments.

In some embodiments, the storage device 1600 may include a memory (or storage) controller 1610 and a non-volatile memory device 1620. The memory controller 1610 may transmit an address ADDR and a command CMD to a nonvolatile memory device 1620 and exchange data DATA with the nonvolatile memory device 1620. In some embodiments, the memory controller 1610 may transmit a command to the nonvolatile memory device 1620 instructing a read operation and an address where the read data is stored. For example, the memory controller 1610 may transmit a command for instructing a read operation and an address where read data is stored to the nonvolatile memory device 1620 based on a request signal from an external device (e.g., a host). The memory controller 1610 may transmit a command including address information of data to be read and size information of data to be read to the nonvolatile memory device 1620. The memory controller 1610 may be, for example, a logic chip or a processor (e.g., a hardware circuit), such as a microprocessor, and may additionally include firmware or software configured to perform the various functions described herein.

In some embodiments, a memory cell array 1625 of a nonvolatile memory device 1620 may store data. The memory cell array 1625 may be connected to the row decoder 1623 through a string selection line SSL, a word line WL, a bit line selection line BSL, and a ground selection line GSL. The row decoder 1623 may provide voltages of various levels to each of the string selection line SSL, word line WL, bit line selection line BSL, and ground selection line GSL under the control of the control logic 1621.

In some embodiments, the memory cell array 1625 may include a plurality of string selection transistors connected to a plurality of string selection lines SSLs and a plurality of bit lines BLs, a plurality of memory cells connected to a plurality of word lines WLs, a plurality of bit line selection transistors connected to a plurality of bit line selection lines BSLs, and a plurality of ground selection transistors connected to a plurality of ground selection lines GSLs and a plurality of common source lines. A plurality of string selection transistors, a plurality of memory cells, a plurality of bit line selection transistors, and a plurality of ground selection transistors may form a plurality of NAND strings.

In some embodiments, the control logic 1621 may control the row decoder 1623 based on a command CMD received from the memory controller 1610. Specifically, the control logic 1621 (which may be a logic circuit or a control circuit) may control the row decoder 1623 based on the size information of data in the command CMD received from the memory controller 1610. The control logic 1621 may control the row decoder 1623 to provide different voltage levels to each of the bit line selection line BSL and the ground selection line GSL based on the size information of the data in the command CMD received from the memory controller 1610.

In some embodiments, the control logic 1621 may receive a command from the memory controller 1610 instructing to read data of a first size. In some embodiments, the control logic 1621 may implement the operations described in FIGS. 2 to 6 based on the size and address information of data received from the memory controller 1610. For example, the control logic 1621 may selection a first plurality of string selection lines among a plurality of string selection lines based on the size and address information of data received from the memory controller 1610, and electrically connect the selected string selection line and the common source line. For example, a smaller number of strings may be selected per page, to result in smaller page sizes, and vice versa. The control logic 1621 may control the row decoder 1623 to implement the operations described in FIGS. 2 to 6 based on the size and address information of data received from the memory controller 1610. The row decoder 1623 may provide different voltage levels to the ground selection line GSL based on the control of the control logic 1621.

In some embodiments, the control logic 1621 may receive a command from the memory controller 1610 instructing it to read data of a second size. In some embodiments, the control logic 1621 may implement the operations described in FIGS. 7 to 10 based on the size and address information of data received from the memory controller 1610. For example, the control logic 1621 may program the plurality of bit line selection transistors with a first plurality of threshold voltages and apply the first plurality of voltages to the plurality of bit line selection lines based on a command instructing to read data of a second size. For example, the control logic 1621 may selection a first plurality of bit lines among the plurality of bit lines based on the size and address information of data received from the memory controller 1610, and electrically connect the first plurality of NAND strings corresponding to the first plurality of bit lines selected among the plurality of NAND strings, the first plurality of bit lines, and the common source line. The control logic 1621 may electrically insulate the second plurality of NAND strings corresponding to the second plurality of bit lines that are not selected among the plurality of NAND strings, the second plurality of bit lines, and the common source line based on the size and address information of the data received from the memory controller 1610. The control logic 1621 may control the row decoder 1623 to implement the operations described in FIGS. 7 to 10 based on the size and address information of data received from the memory controller 1610. The row decoder 1623 may provide different voltage levels to each of the bit line selection line BSL and the ground selection line GSL based on the control of the control logic 1621.

In some embodiments, the control logic 1621 may receive a command from the memory controller 1610 instructing it to read data of a third size. In some embodiments, the control logic 1621 may implement the operations described in FIGS. 11 to 15 based on the size and address information of data received from the memory controller 1610. For example, the control logic 1621 may program the plurality of bit line selection transistors with a second plurality of threshold voltages and apply the second plurality of voltages to the plurality of bit line selection lines based on a command instructing to read out data of a third size. The control logic 1621 may control the row decoder 1623 to implement the operations described in FIGS. 11 to 15 based on the size and address information of data received from the memory controller 1610. The row decoder 1623 may provide different voltage levels to each of the bit line selection line BSL and the ground selection line GSL based on the control of the control logic 1621.

According to the above embodiments, a storage device includes a storage controller configured to output a command instructing reading of data, and a nonvolatile memory device. The nonvolatile memory device includes a plurality of bit lines extending in a first horizontal direction (e.g., bit lines BL1 through BLm in FIGS. 2, 7, etc., extending in the D1 direction), a plurality of word lines extending in a second horizontal direction (e.g., word lines WL1 through WLn in FIGS. 2, 7, etc., extending in the D2 direction), a plurality of selection lines extending in the second horizontal direction (e.g., any of the ground selection lines or bit line selection lines described in the various embodiments), each selection line connecting to a set of selection transistors (e.g., bit lines selection transistors or ground line selection transistors) arranged in the second horizontal direction, a common source line (e.g., CSL), wherein the plurality of word lines and plurality of selection lines are vertically between the common source line and the plurality of bit lines, a plurality of string select lines (e.g., SSL1 through SSLa) extending in the second horizontal direction, and a plurality of NAND strings (e.g., NS11 through NSam), each extending from a bit line of the plurality of bit lines to the common source line, and connected to the plurality of word lines, the plurality of selection lines, and one of the string select lines.

The nonvolatile memory device is configured to, in response to the command, apply a first voltage (e.g., V2 from FIG. 4) to a group of selection transistors connected to a first selection line of the plurality of selection lines, and in response to applying of the first voltage, turn on a first set of selection transistors of the group of selection transistors, the first set of selection transistors having threshold voltages within a first threshold voltage distribution (e.g., S1 from FIG. 4) below the first voltage, and turn off a second set of selection transistors of the group of selection transistors, the second set of selection transistors having threshold voltages within a second threshold voltage distribution (e.g., S2 from FIG. 4) above the first voltage. Turning off of the second set of selection transistors electrically disconnects, for each turned-off selection transistor, the common source line from a bit line connected to the turned-off selection transistor.

The plurality of selection lines may include ground select lines (GSL) and bit line select lines (BSL). For example, the first selection line may be a ground select line. In addition, the plurality of selection lines may include a plurality of bit line select lines, and the nonvolatile memory device may be configured to apply different voltages to different bit line select lines of the plurality of bit select lines in order to change a page size of a page being read from the nonvolatile memory device.

Therefore, according to some embodiments, a bit line selection transistor connected to a bit line selection line may be turned on or off depending on a voltage applied to the bit line selection line. The electrical connection of the bit lines and common source lines to the NAND strings may be controlled depending on the voltage applied to the bit line selection line.

Embodiments are set out in the following clauses:
Clause 1. A storage device, comprising: a storage controller configured to output a command instructing reading of data, and a nonvolatile memory device including a plurality of NAND strings corresponding to a plurality of bit lines and a plurality of string selection lines, and configured to: select a plurality of first bit lines among the plurality of bit lines based on the command, electrically connect a plurality of first NAND strings corresponding to the plurality of first bit lines among the plurality of NAND strings to the plurality of first bit lines and a common source line, and electrically disconnect a plurality of second NAND strings corresponding to a plurality of second bit lines among the plurality of NAND strings from the plurality of second bit lines and the common source line.
Clause 2. The storage device of Clause 1, wherein: the nonvolatile memory device comprises: a plurality of string selection transistors configured to form the plurality of NAND strings and connected to the plurality of string selection lines and the plurality of bit lines, a plurality of memory cells configured to form the plurality of NAND strings and connected to a plurality of word lines, a plurality of ground selection transistors configured to form the plurality of NAND strings and connected to a plurality of ground selection lines and the common source line, and a plurality of bit line selection transistors configured to form the plurality of NAND strings and connected to a plurality of bit line selection lines.
Clause 3. The storage device of Clause 2, wherein: the plurality of word lines are stacked from lowest to highest; a plurality of first bit line selection lines among the plurality of bit line selection lines are located between the highest word line among the plurality of word lines and the plurality of string selection lines, and a plurality of second bit line selection lines among the plurality of bit line selection lines are located between the lowest word line among the plurality of word lines and the plurality of ground selection lines.
Clause 4. The storage device of Clause 3, wherein: the nonvolatile memory device is configured to apply a plurality of first voltages to the plurality of ground selection lines based on the command, electrically connect a plurality of first string selection lines among the plurality of string selection lines to the common source line, apply a plurality of second voltages to the plurality of bit line selection lines, and electrically connect the plurality of first NAND strings to the plurality of first bit lines and the common source line.
Clause 5. The storage device of Clause 4, wherein: each of the plurality of bit line selection transistors has a threshold voltage within a first threshold voltage distribution or a second threshold voltage distribution.
Clause 6. The storage device of Clause 3, 4 or 5, wherein: among the plurality of bit line selection transistors, bit line selection transistors connected to the same bit line selection line and corresponding to the plurality of first bit lines have threshold voltages within the same threshold voltage distribution as each other.
Clause 7. The storage device of Clause 6, wherein: the nonvolatile memory device is configured to apply a third voltage to a first bit line selection line among the plurality of first bit line selection lines and a third bit line selection line among the plurality of second bit line selection lines and apply a fourth voltage different from the third voltage to a second bit line selection line among the plurality of first bit line selection lines and a fourth bit line selection line among the plurality of second bit line selection lines.
Clause 8. The storage device of Clause 7, wherein: a plurality of first bit line selection transistors connected to the first bit line selection line and the third bit line selection line are turned-on by the third voltage, a plurality of second bit line selection transistors forming the plurality of first NAND strings, among bit line selection transistors connected to the second bit line selection line and the fourth bit line selection line, are turned-on by the fourth voltage, and a plurality of third bit line selection transistors forming the plurality of second NAND strings are turned-off by a fifth voltage lower than the third voltage and the fourth voltage.
Clause 9. A nonvolatile memory device, comprising: a memory cell array including a plurality of string selection transistors connected to a plurality of string selection lines and a plurality of bit lines including a plurality of bit line groups, a plurality of memory cells connected to a plurality of word lines, a plurality of bit line selection transistors connected to a plurality of bit line selection lines, and a plurality of ground selection transistors connected to a plurality of ground selection lines and a common source line, and a control circuit configured to apply a plurality of first voltages to the plurality of ground selection lines, connect a selected plurality of first string selection lines among the plurality of string selection lines to the common source line, select a first bit line group among the plurality of bit line groups, apply a plurality of second voltages to the plurality of bit line selection lines, and electrically connect a plurality of second NAND strings corresponding to the first bit line group, among a plurality of first NAND strings corresponding to the plurality of first string selection lines, to a corresponding plurality of bit lines and the common source line.
Clause 10. The nonvolatile memory device of Clause 9, wherein: the control circuit is configured to program the plurality of bit line selection transistors so that the plurality of bit line selection transistors have a predetermined threshold voltage distribution.
Clause 11. The nonvolatile memory device of Clause 10, wherein: a plurality of bit line selection transistors connected to a first bit line selection line among the plurality of bit line selection lines and included in the plurality of second NAND strings have threshold voltages within the same threshold voltage distribution as each other.
Clause 12. The nonvolatile memory device of Clause 11, wherein: the plurality of second NAND strings include bit line selection transistors that are turned-on by the plurality of second voltages applied to the plurality of bit line selection lines, and remaining NAND strings among the plurality of first NAND strings except for the plurality of second NAND strings include at least one bit line selection transistor that is turned-off by the plurality of second voltages applied to the plurality of bit line selection lines.
Clause 13. The nonvolatile memory device of any one of Clauses 9 to 12, wherein: the plurality of word lines are arranged vertically from a highest word line to a lowest word line; a plurality of bit line selection lines among the plurality of bit line selection lines are located between the highest word line among the plurality of word lines and the plurality of string selection lines, and a plurality of second bit line selection lines among the plurality of bit line selection lines are located between the lowest word line among the plurality of word lines and the plurality of ground selection lines.
Clause 14. The nonvolatile memory device of any one of Clauses 9 to 13, further comprising: a plurality of page buffers corresponding to the plurality of bit lines, wherein the control circuit is configured to activate page buffers corresponding to the first bit line group among the plurality of page buffers.
Clause 15. A storage device, comprising: a memory controller configured to output a first command instructing reading of a first size data and a second command instructing reading of a second size data, and a nonvolatile memory device including a plurality of NAND strings, wherein the plurality of NAND strings include a plurality of string selection transistors connected to a plurality of bit lines including a plurality of bit line groups and a plurality of first string selection lines among a plurality of string selection lines, a plurality of memory cells connected to a plurality of word lines, a plurality of bit line selection transistors connected to a plurality of bit line selection lines, and a plurality of ground selection transistors connected to a plurality of ground selection lines and a common source line, and wherein the nonvolatile memory device is configured to program the plurality of bit line selection transistors with a plurality of first threshold voltages and apply a plurality of first voltages to the plurality of bit line selection lines based on the first command, and program the plurality of bit line selection transistors with a plurality of second threshold voltages and apply a plurality of second voltages to the plurality of bit line selection lines based on the second command.
Clause 16. The storage device of Clause 15, wherein: the nonvolatile memory device is configured to: select a first bit line group among the plurality of bit line groups based on the first command, and program first bit line selection transistors to have threshold voltages within a first threshold voltage distribution, wherein the first bit line selection transistors are connected to a first bit line selection line and correspond to the first bit line group, and select a second bit line group among the plurality of bit line groups based on the second command, and program second bit line selection transistors to have threshold voltages within a second threshold voltage distribution that does not overlap the first threshold voltage distribution, wherein the second bit line selection transistors are connected to a second bit line selection line and correspond to the second bit line group.
Clause 17. The storage device of Clause 16, wherein: the nonvolatile memory device is configured to: electrically connect a plurality of first NAND strings corresponding to the first bit line group among the plurality of NAND strings to bit lines in the first bit line group and to the common source line based on the first command, and electrically connect a plurality of second NAND strings corresponding to the second bit line group among the plurality of NAND strings to bit lines in the second bit line group and to the common source line based on the second command.
Clause 18. The storage device of Clause 17, wherein: the nonvolatile memory device is configured to: electrically disconnect a plurality of third NAND strings corresponding to a third bit line group different from the first bit line group among the plurality of NAND strings from being electrically connected between a plurality of bit lines in the third bit line group and the common source line based on the first command, and electrically disconnect a plurality of fourth NAND strings corresponding to a fourth bit line group different from the second bit line group among the plurality of NAND strings from being electrically connected between a plurality of bit lines in the fourth bit line group and the common source line based on the second command.
Clause 19. The storage device of Clause 17 or 18, wherein: a plurality of bit line selection transistors in the plurality of first NAND strings are turned-on based on the plurality of first voltages, and a plurality of bit line selection transistors in the plurality of second NAND strings are turned-on based on the plurality of second voltages.
Clause 20. The storage device of any one of Clauses 17 to 19, wherein: the nonvolatile memory device is configured to: output data stored in a memory cell connected to a first word line among the plurality of word lines and included in the plurality of first NAND strings based on the first command, and output data stored in a memory cell connected to a second word line among the plurality of word lines and included in the plurality of second NAND strings based on the second command.

Although the embodiments of the present invention have been described in detail above, the scope of the present invention is not limited thereto, and various modifications and improvements made by those skilled in the art using the basic concept of the present invention may also fall within the scope of the present invention.

## Claims

1. A storage device (1600), comprising:
a storage controller (1610) configured to output a command (CMD) instructing reading of data, and
a nonvolatile memory device (1620) including a plurality of NAND strings corresponding to a plurality of bit lines (BL) and a plurality of string selection lines (SSL), and configured to: select a plurality of first bit lines (BL) among the plurality of bit lines (BL) based on the command (CMD), electrically connect a plurality of first NAND strings corresponding to the plurality of first bit lines (BL) among the plurality of NAND strings to the plurality of first bit lines (BL) and a common source line (CSL), and electrically disconnect a plurality of second NAND strings corresponding to a plurality of second bit lines (BL) among the plurality of NAND strings from the plurality of second bit lines (BL) and the common source line (CSL).

2. The storage device of claim 1, wherein:
the nonvolatile memory device (1620) comprises:
a plurality of string selection transistors (SST) configured to form the plurality of NAND strings and connected to the plurality of string selection lines (SSL) and the plurality of bit lines (BL),
a plurality of memory cells configured to form the plurality of NAND strings and connected to a plurality of word lines (WL),
a plurality of ground selection transistors (GST) configured to form the plurality of NAND strings and connected to a plurality of ground selection lines (GSL) and the common source line (CSL), and
a plurality of bit line selection transistors (BST) configured to form the plurality of NAND strings and connected to a plurality of bit line selection lines (BSL).

3. The storage device of claim 2, wherein:
the plurality of word lines (WL) are stacked from lowest to highest;
a plurality of first bit line selection lines (BSL) among the plurality of bit line selection lines (BSL) are located between the highest word line (WL) among the plurality of word lines (WL) and the plurality of string selection lines (SSL), and
a plurality of second bit line selection lines (BSL) among the plurality of bit line selection lines (BSL) are located between the lowest word line (WL) among the plurality of word lines (WL) and the plurality of ground selection lines (GSL).

4. The storage device of claim 2 or 3, wherein:
the nonvolatile memory device (1620) is configured to apply a plurality of first voltages to the plurality of ground selection lines (GSL) based on the command (CMD), electrically connect a plurality of first string selection lines (SSL) among the plurality of string selection lines (SSL) to the common source line (CSL), apply a plurality of second voltages to the plurality of bit line selection lines (BLS), and electrically connect the plurality of first NAND strings to the plurality of first bit lines (BL) and the common source line (CSL).

5. The storage device of any one of claims 2, 3 or 4, wherein:
each of the plurality of bit line selection transistors (BST) has a threshold voltage within a first threshold voltage distribution or a second threshold voltage distribution.

6. The storage device of any one of claims 2 to 5, wherein:
among the plurality of bit line selection transistors (BST), bit line selection transistors (BST) connected to the same bit line selection line (BSL) and corresponding to the plurality of first bit lines (BL) have threshold voltages within the same threshold voltage distribution as each other.

7. The storage device of any one of claims 3 to 6, wherein:
the nonvolatile memory device (1620) is configured to apply a third voltage to a first bit line selection line (BSL) among the plurality of first bit line selection lines (BSL) and a third bit line selection line (BSL) among the plurality of second bit line selection lines (BSL) and apply a fourth voltage different from the third voltage to a second bit line selection line (BSL) among the plurality of first bit line selection lines (BSL) and a fourth bit line selection line (BSL) among the plurality of second bit line selection lines (BSL).

8. The storage device of claim 7, wherein:
a plurality of first bit line selection transistors (BST) connected to the first bit line selection line (BSL) and the third bit line selection line (BSL) are turned-on by the third voltage, a plurality of second bit line selection transistors (BST) forming the plurality of first NAND strings, among bit line selection transistors (BST) connected to the second bit line selection line (BSL) and the fourth bit line selection line (BSL), are turned-on by the fourth voltage, and a plurality of third bit line selection transistors (BST) forming the plurality of second NAND strings are turned-off by a fifth voltage lower than the third voltage and the fourth voltage.

9. A nonvolatile memory device (1620), comprising:
a memory cell array (1625) including a plurality of string selection transistors (SST) connected to a plurality of string selection lines (SSL) and a plurality of bit lines (BL) including a plurality of bit line groups (BL), a plurality of memory cells connected to a plurality of word lines (WL), a plurality of bit line selection transistors (BLT) connected to a plurality of bit line selection lines (BSL), and a plurality of ground selection transistors (GST) connected to a plurality of ground selection lines (GSL) and a common source line (CSL), and
a control circuit (1621) configured to apply a plurality of first voltages to the plurality of ground selection lines (GSL), connect a selected plurality of first string selection lines (SSL) among the plurality of string selection lines (SSL) to the common source line (CSL), select a first bit line group (BL) among the plurality of bit line groups (BL), apply a plurality of second voltages to the plurality of bit line selection lines (BSL), and electrically connect a plurality of second NAND strings corresponding to the first bit line group (BL), among a plurality of first NAND strings corresponding to the plurality of first string selection lines (SSL), to a corresponding plurality of bit lines (BL) and the common source line (CSL).

10. The nonvolatile memory device of claim 9, wherein:
the control circuit (1621) is configured to program the plurality of bit line selection transistors (BST) so that the plurality of bit line selection transistors (BST) have a predetermined threshold voltage distribution.

11. The nonvolatile memory device of claim 9 or 10, wherein:
a plurality of bit line selection transistors (BST) connected to a first bit line selection line (BSL) among the plurality of bit line selection lines (BSL) and included in the plurality of second NAND strings have threshold voltages within the same threshold voltage distribution as each other.

12. The nonvolatile memory device of claim 9, 10 or 11, wherein:
the plurality of second NAND strings include bit line selection transistors (BST) that are turned-on by the plurality of second voltages applied to the plurality of bit line selection lines (BSL), and
remaining NAND strings among the plurality of first NAND strings except for the plurality of second NAND strings include at least one bit line selection transistor (BST) that is turned-off by the plurality of second voltages applied to the plurality of bit line selection lines (BSL).

13. The nonvolatile memory device of any one of claims 9 to 12, wherein:
the plurality of word lines (WL) are arranged vertically from a highest word line (WL) to a lowest word line (WL);
a plurality of bit line selection lines (BSL) among the plurality of bit line selection lines (BSL) are located between the highest word line (WL) among the plurality of word lines (WL) and the plurality of string selection lines (SSL), and a plurality of second bit line selection lines (BSL) among the plurality of bit line selection lines (BSL) are located between the lowest word line (WL) among the plurality of word lines (WL) and the plurality of ground selection lines (GSL).

14. The nonvolatile memory device of any one of claims 9 to 13, further comprising:
a plurality of page buffers (25) corresponding to the plurality of bit lines (BL),
wherein the control circuit (1621) is configured to activate page buffers (25) corresponding to the first bit line group (BL) among the plurality of page buffers (25).

15. The storage device of claim 1, wherein:
the storage controller (1610) is configured to output a first command instructing reading of a first size data and a second command instructing reading of a second size data, and
the plurality of NAND strings include a plurality of string selection transistors (SST) connected to the plurality of bit lines (BL) including a plurality of bit line groups (BL) and a plurality of first string selection lines (SSL) among the plurality of string selection lines (SSL), a plurality of memory cells connected to a plurality of word lines (WL), a plurality of bit line selection transistors (BST) connected to a plurality of bit line selection lines (BSL), and a plurality of ground selection transistors (GST) connected to a plurality of ground selection lines (GSL) and the common source line (CSL), and
wherein the nonvolatile memory device is configured to program the plurality of bit line selection transistors (BST) with a plurality of first threshold voltages and apply a plurality of first voltages to the plurality of bit line selection lines (BSL) based on the first command, and program the plurality of bit line selection transistors (BST) with a plurality of second threshold voltages and apply a plurality of second voltages to the plurality of bit line selection lines (BSL) based on the second command.
